# EUROPEAN PATENT APPLICATION

(11) **EP 4 553 905 A1**
(43) Date of publication of application: **14.05.2025**
(21) Application number: 23850394.0
(22) Date of filing: 01.08.2023
(51) Int. Cl.: H01L 27/15, H01L 33/44, H01L 33/62, H01L 25/075, H01L 27/12, H01L 33/38

(54) **CONDUCTIVE ELEMENT, DISPLAY DEVICE, AND METHOD FOR MANUFACTURING DISPLAY DEVICE**

(30) Priority: 03.08.2022 KR 20220096970
(71) Applicant: Samsung Display Co., Ltd., Yongin-si, Gyeonggi-do 17113 (KR)
(72) Inventor: CHOI, Ji Woong, Yongin-si, Gyeonggi-do 17113 (KR)
(74) Representative: Walaski, Jan Filip
(86) International application number: PCT/KR2023/011237
(87) International publication number: WO 2024/029893

(57) **Abstract**

A conductive element may include: a first semiconductor layer adjacent to a first end portion of the conductive element; a second semiconductor layer adjacent to a second end portion of the conductive element; an active layer disposed between the first semiconductor layer and the second semiconductor layer, an element insulating layer covering the active layer and exposing the first end portion and the second end portion; and a conductive pattern layer disposed on the element insulating layer.

## Description

### Technical Field

Various embodiments relate to a conductive element, a display device, and a method of fabricating the conductive element and the display device.

### Background Art

Recently, as interest in information display increases, research and development on display devices have been continuously conducted.

### Detailed Description of Invention

### Technical Problem

Various embodiments are directed to a conductive element that emits light or functions as an electrical connector, a display device including the conductive element, and a method of fabricating the display device.

However, embodiments of the disclosure are not limited to those set forth herein. The above and other embodiments will become more apparent to one of ordinary skill in the art to which the disclosure pertains by referencing the detailed description of the disclosure given below.

### Technical Solution

One or more embodiments may provide a conductive element including: a first semiconductor layer adjacent to a first end portion of the conductive element; a second semiconductor layer adjacent to a second end portion of the conductive element; an active layer disposed between the first semiconductor layer and the second semiconductor layer; an element insulating layer covering the active layer and exposing the first end portion and the second end portion; and a conductive pattern layer disposed on the element insulating layer.

In one or more embodiments, the conductive pattern layer may surround the element insulating layer in a cross-sectional direction of the conductive element. The cross-sectional direction may be different from a direction from the first end portion toward the second end portion.

In one or more embodiments, the conductive pattern layer may include a conductive material, and may be electrically insulated from the first semiconductor layer, the second semiconductor layer, and the active layer by the element insulating layer.

In one or more embodiments, the conductive pattern layer may expose a first portion of the element insulating layer adjacent to the first end portion and a second portion of the element insulating layer adjacent to the second end portion.

In one or more embodiments, the conductive pattern layer may have a thickness in a range of about 200 nm to about 350 nm.

In one or more embodiments, the conductive element may have a first length in a direction from the first end portion toward the second end. The conductive pattern layer may have a second length in the direction from the first end portion toward the second end portion. A ratio of the first length to the second length may be in a range of about 1.3 to about 1.6.

One or more embodiments may provide a display device including: a pad line disposed in a pad area on a base layer and including a first alignment pad line and a second alignment pad line; a conductive element including at least a portion disposed on the first alignment pad line and the second alignment pad line; and a chip-on-film including a first portion electrically connected to the conductive element and a second portion electrically connected to a flexible circuit component. The conductive element may include: a first semiconductor layer adjacent to the first end portion of the conductive element; a second semiconductor layer adjacent to the second end portion of the conductive element; an active layer disposed between the first semiconductor layer and the second semiconductor layer; an element insulating layer covering the active layer and exposing the first end portion and the second end portion; and a conductive pattern layer disposed on the element insulating layer. The conductive pattern layer may electrically connect the pad line to the chip-on-film.

In one or more embodiments, the first alignment pad line and the second alignment pad line may be spaced apart from each other. The conductive element may include a plurality of conductive elements disposed between the first alignment pad line and the second alignment pad line.

In one or more embodiments, the conductive pattern layer may physically contact at least a portion of the pad line.

In one or more embodiments, the pad line may include a first connection pad line on the first alignment pad line, and a second connection pad line on the second alignment pad line. The first alignment pad line and the second alignment pad line may be spaced apart from each other. A first portion of the conductive pattern layer may physically contact the first connection pad line, and a second portion of the conductive pattern layer may physically contact the second connection pad line.

In one or more embodiments, a distance between the first alignment pad line and the second alignment pad line may be smaller than a length of the conductive pattern layer.

In one or more embodiments, the display device may further include: a non-conductive coupling layer coupling the chip-on-film to at least some of components disposed on the base layer; and a conductive connector disposed between the chip-on-film and the conductive pattern layer and electrically connecting the chip-on-film to the conductive pattern layer.

In one or more embodiments, the display device may further include electrodes disposed in a display area on the base layer, each electrode including a first electrode and a second electrode. A portion of the conductive element may be aligned between the first electrode and the second electrode to emit light in the display area.

In one or more embodiments, the display device may further include: a first insulating layer disposed on the first electrode and the second electrode; and insulating pattern layers disposed on the first insulating layer, and protruding in a thickness direction of the base layer.

In one or more embodiments, the display device may further include: a first connection electrode electrically connected to the first end portion of the conductive element in the display area; and a second connection electrode electrically connected to the second end portion of the conductive element in the display area. The first connection electrode and the second connection electrode may be electrically insulated from the conductive pattern layer.

In one or more embodiments, the display device may further include: a first connection electrode electrically connected to the first end portion of the conductive element in the display area; and a second connection electrode electrically connected to the second end portion of the conductive element in the display area. The first connection electrode and the second connection electrode may be electrically insulated from the conductive pattern layer, and are formed of a same layer.

In one or more embodiments, the display device may further include a first insulating layer disposed on the first electrode and the second electrode. The conductive element and the first insulating layer in the display area may form an empty space in an area where the conductive pattern layer is not disposed.

In one or more embodiments, the display device may further include a second insulating layer entirely covering the conductive pattern layer of the conductive element in the display area.

One or more embodiments may provide a display device including: a first electrode and a second electrode disposed on a base layer; a conductive element disposed on the first electrode and the second electrode; a first connection electrode electrically connected to a first end portion of the conductive element; and a second connection electrode electrically connected to a second end portion of the conductive element. The conductive element may include: a first semiconductor layer adjacent to the first end portion; a second semiconductor layer adjacent to the second end portion; an active layer disposed between the first semiconductor layer and the second semiconductor layer; an element insulating layer covering the active layer and exposing the first end portion and the second end portion; and a conductive pattern layer disposed on the element insulating layer.

One or more embodiments may provide a display device including: a pad line disposed on a base layer; a plurality of conductive elements electrically connected to the pad line; a chip-on-film including a first portion electrically connected to the plurality of conductive elements, and a second portion electrically connected to a flexible circuit component; and a non-conductive coupling layer coupling the chip-on-film to some of components disposed on the base layer.

One or more embodiments may provide a method of fabricating a display device including: disposing electrodes on a base layer including a pad area and a display area, the electrodes including alignment pad lines disposed in the pad area and alignment electrodes disposed in the display area; disposing conductive elements on the alignment electrodes in the display area; patterning connection electrodes on the base layer; disposing the conductive elements on the alignment pad lines in the pad area; and electrically connecting a chip-on-film to the conductive elements in the pad area. The chip-on-film may be electrically connected to a flexible circuit component.

In one or more embodiments, the disposing of the conductive elements in the display area may include: supplying ink including the conductive elements onto the base layer; applying an alignment signal to each of the electrodes; and aligning the conductive elements on the electrodes by an electric field formed by the alignment signal.

In one or more embodiments, an equipment used to dispose the conductive elements in the display area may be substantially identical to an equipment used to dispose the conductive elements in the pad area.

In one or more embodiments, the patterning of the connection electrodes may include: patterning a first connection electrode and a second connection electrode which are electrically connected to the conductive elements in the display area; and patterning connection pad lines on the alignment pad lines in the pad area.

In one or more embodiments, the each of conductive elements may include: a first semiconductor layer adjacent to a first end portion of each conductive element; a second semiconductor layer adjacent to a second end portion of each conductive element; an active layer disposed between the first semiconductor layer and the second semiconductor layer; an element insulating layer covering the active layer and exposing the first end portion and the second end portion; and a conductive pattern layer disposed on the element insulating layer. The disposing of the conductive elements in the pad area may include disposing the connection pad lines into contact with the conductive pattern layer.

In one or more embodiments, electrically connecting the chip-on-film to the conductive elements in the pad area may include electrically connecting the conductive pattern layer to the chip-on-film through a conductive connector.

### Advantageous Effects

Various embodiments may provide a conductive element that emits light or functions as an electrical connector. For example, the conductive element may function as a light emitting element in a display area. The conductive element may function as a pad connector in the pad area. Therefore, respective processes in a display area and a pad area may be integrated with each other, so that the processability may be enhanced.

### Description of Drawings

FIG. 1 is a schematic perspective view illustrating a conductive element in accordance with one or more embodiments.
FIG. 2 is a schematic sectional view illustrating the conductive element in accordance with one or more embodiments.
FIG. 3 is a schematic perspective view illustrating a display device in accordance with one or more embodiments.
FIG. 4 is a schematic plan view illustrating the display device in accordance with one or more embodiments.
FIG. 5 is a schematic block diagram for describing an electrical connection structure of the conductive element in a display area in accordance with one or more embodiments.
FIG. 6 is a schematic plan view illustrating a sub-pixel in accordance with one or more embodiments.
FIGS. 7 to 10 are schematic sectional views each illustrating a sub-pixel in accordance with one or more embodiments.
FIG. 11 is a schematic sectional view illustrating a pixel in accordance with one or more embodiments.
FIG. 12 is a schematic sectional view illustrating a sub-pixel in accordance with one or more embodiments.
FIG. 13 is a schematic block diagram for describing an electrical connection structure of the conductive element in a pad area in accordance with one or more embodiments.
FIGS. 14 and 15 are schematic views illustrating a pad area in accordance with one or more embodiments.
FIG. 16 is a schematic flowchart illustrating a method of fabricating a display device in accordance with one or more embodiments.
FIGS. 17 to 24 are schematic views illustrating, by process steps, a method of fabricating the display device in accordance with one or more embodiments.

### Modes of the Invention

In the following description, for the purposes of explanation, numerous specific details are set forth in order to provide a thorough understanding of various embodiments or implementations of the invention. As used herein "embodiments" and "implementations" are interchangeable words that are non-limiting examples of devices or methods disclosed herein. It is apparent, however, that various embodiments may be practiced without these specific details or with one or more equivalent arrangements. Here, various embodiments do not have to be exclusive nor limit the disclosure. For example, specific shapes, configurations, and characteristics of an embodiment may be used or implemented in another embodiment.

Unless otherwise specified, the illustrated embodiments are to be understood as providing features of the invention. Therefore, unless otherwise specified, the features, components, modules, layers, films, panels, regions, and/or aspects, etc. (hereinafter individually or collectively referred to as "elements"), of the various embodiments may be otherwise combined, separated, interchanged, and/or rearranged without departing from the invention.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless otherwise specified. Further, in the accompanying drawings, the size and relative sizes of elements may be exaggerated for clarity and/or descriptive purposes. When an embodiment may be implemented differently, a specific process order may be performed differently from the described order. For example, two consecutively described processes may be performed substantially at the same time or performed in an order opposite to the described order. Also, like reference numerals denote like elements.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the DR1-axis, the DR2-axis, and the DR3-axis are not limited to three axes of a rectangular coordinate system, such as the X, Y, and Z - axes, and may be interpreted in a broader sense. For example, the DR1-axis, the DR2-axis, and the DR3-axis may be perpendicular to one another, or may represent different directions that are not perpendicular to one another. Further, the X-axis, the Y-axis, and the Z-axis are not limited to three axes of a rectangular coordinate system, such as the X, Y, and Z axes, and may be interpreted in a broader sense. For example, the X-axis, the Y-axis, and the Z-axis may be perpendicular to one another, or may represent different directions that are not perpendicular to one another. For the purposes of this disclosure, "at least one of A and B" may be construed as understood to mean A only, B only, or any combination of A and B. Also, "at least one of X, Y, and Z" and "at least one selected from the group consisting of X, Y, and Z" may be construed as X only, Y only, Z only, or any combination of two or more of X, Y, and Z. As used herein, the term "and/or" includes any and all combinations of one or more of the associated listed items.

Although the terms "first," "second," etc. may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (e.g., as in "sidewall"), and the like, may be used herein for descriptive purposes, and, thereby, to describe one elements relationship to another element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the term "below" can encompass both an orientation of above and below. Furthermore, the apparatus may be otherwise oriented (e.g., rotated 90 degrees or at other orientations), and, as such, the spatially relative descriptors used herein interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various embodiments are described herein with reference to sectional and/or exploded illustrations that are schematic illustrations of embodiments and/or intermediate structures. As such, variations from the shapes of the illustrations as a result, for example, of manufacturing techniques and/or tolerances, are to be expected. Thus, embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

Various embodiments relate to a conductive element, a display device, and a method of fabricating the display device. Hereinafter, a conductive element, a display device, and a method of fabricating the display device in accordance with one or more embodiments will be described with reference to the attached drawings.

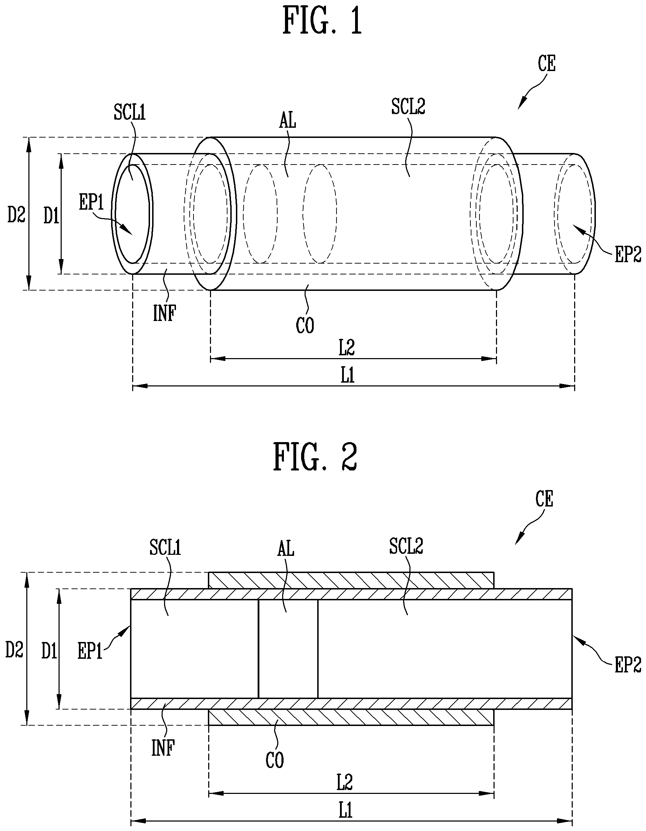

A conductive element CE in accordance with one or more embodiments will be described with reference to FIGS. 1 and 2. FIG. 1 is a schematic perspective view illustrating the conductive element CE in accordance with one or more embodiments. FIG. 2 is a schematic sectional view illustrating the conductive element CE in accordance with one or more embodiments.

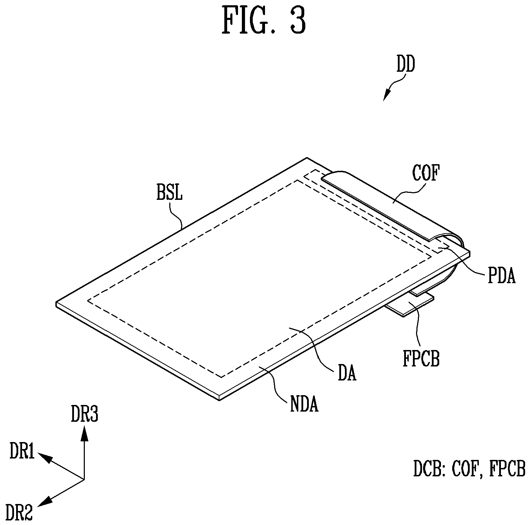

The conductive element CE may function as a light emitting element and/or an electrical connector. For example, the conductive element CE may function as a light emitting element in a display area DA (refer to FIG. 3). The conductive element CE may function as an electrical connector in a pad area PDA (refer to FIG. 3).

In accordance with one or more embodiments, the conductive element CE may be formed to emit light. For example, the conductive element CE may emit light in case that an electrical signal is applied thereto. The conductive element CE may emit light in case that an anode signal is supplied from a first end portion EP1 and a cathode signal is supplied from a second end portion EP2.

In accordance with one or more embodiments, the conductive element CE may form an electrical path in a direction. For example, an exposed outer side surface of the conductive element CE may have conductive properties, and the conductive element CE may electrically connect a first component to a second component spaced apart from the first component. The conductive element CE may form an electrical path in a direction opposite to a direction from the first end portion EP1 to the second end portion EP2.

The conductive element CE may have various shapes. For example, the conductive element CE may extend in a direction. FIGS. 1 and 2 illustrate one or more embodiments in which the conductive element CE has a pillar shape. For example, the conductive element CE may extend from the first end portion EP1 to the second end portion EP2. In one or more embodiments, a first length L1 of the conductive element CE may be greater than a first diameter D1 of the conductive element CE. In one or more embodiments, in case that the conductive element CE may have a rod shape, the conductive element CE may be referred to as a rod-type conductive element.

In one or more embodiments, the conductive element CE may have a shape in which a central area thereof protrudes farther than a peripheral area thereof. In one or more embodiments, based on a conductive pattern layer CO, at least a portion of the conductive element CE may protrude toward the first end portion EP1, and at least another portion of the conductive element CE may protrude toward the second end portion EP2.

In one or more embodiments, the conductive pattern layer CO may be selectively disposed on the outer surface (e.g., an outer side surface) of the conductive element CE. For example, the conductive element CE may have a first diameter D1 in an area where the conductive pattern layer CO is not disposed, and may have a second diameter D2 in an area where the conductive pattern layer CO is disposed. For example, the first diameter D1 may be smaller than the second diameter D2.

The conductive element CE may include a first semiconductor layer SCL1, a second semiconductor layer SCL2, and an active layer AL. The conductive element CE may further include an element insulating layer INF and a conductive pattern layer CO. The conductive pattern layer CO may also be referred to as a conductive coating layer. The conductive pattern layer CO may also be referred to as an outer side conductive layer.

The conductive element CE may include a first end portion EP1 and a second end portion EP2. In one or more embodiments, the first semiconductor layer SCL1 may be adjacent to the first end portion EP1 of the conductive element CE. The second semiconductor layer SCL2 may be adjacent to the second end portion EP2 of the conductive element CE. The active layer AL may be disposed between the first semiconductor layer SCL1 and the second semiconductor layer SCL2.

The conductive element CE may be formed by etching a stack structure formed by successively stacking semiconductor layers. Furthermore, the conductive element CE may be formed by patterning an element insulating layer INF on outer surfaces of the first semiconductor layer SCL1, the second semiconductor layer SCL2, and the active layer AL, and patterning the conductive pattern layer CO on the element insulating layer INF. For example, the conductive pattern layer CO may be disposed on the element insulating layer INF through a sputtering process. However, embodiments are not limited thereto.

The conductive element CE may have a size in a range of the nanometer scale to the micrometer scale. For example, the first diameter D1 and the second diameter D2 may have a size in a range of the nanometer scale to the micrometer scale. The first length L1 and a second length L2 may correspond to a size in a range of the nanometer scale to the micrometer scale. In one or more embodiments, the second diameter D2 may be greater than the first diameter D1 by (e.g., about two times of) the thickness of the conductive pattern layer CO. For example, the thickness of the conductive pattern layer CO may be in a range of about 200 nm to about 350 nm. In another example, the thickness of the conductive pattern layer CO may be in a range of about 250 nm to about 300 nm. In one or more embodiments, the second length L2 may be greater than half of the first length L1. For example, a ratio of the first length L1 to the second length L2 may be in a range of about 1.3 to about 1.6. However, embodiments are not limited thereto.

The first semiconductor layer SCL1 may be a first conductive semiconductor layer. The first semiconductor layer SCL1 may be disposed on the active layer AL and may include a semiconductor layer having a type different from that of the second semiconductor layer SCL2. For example, the first semiconductor layer SCL1 may include a P-type semiconductor layer. For instance, the first semiconductor layer SCL1 may include a P-type semiconductor layer which includes at least one semiconductor material of InAlGaN, GaN, AlGaN, InGaN, AlN, and InN, and is doped with a first conductive dopant such as Ga, B, or Mg. However, the material for forming the first semiconductor layer SCL1 is not limited thereto, and the first semiconductor layer SCL1 may be formed of various other materials.

The active layer AL may be disposed between the first semiconductor layer SCL1 and the second semiconductor layer SCL2, and have a single-quantum well structure or a multi-quantum well structure. The location of the active layer AL is not limited to a specific example.

A cladding layer doped with a conductive dopant may be formed on and/or under the active layer AL. For example, the cladding layer may be formed of an AlGaN layer or an InAlGaN layer. In one or more embodiments, a material such as AlGaN or InAlGaN may be used to form the active layer AL, and various other materials may be used to form the active layer AL.

The second semiconductor layer SCL2 may be a second conductive semiconductor layer. The second semiconductor layer SCL2 may be disposed on the active layer AL and may include a semiconductor layer of a type different from that of the first semiconductor layer SCL1. For example, the second semiconductor layer SCL2 may include an N-type semiconductor layer. For instance, the second semiconductor layer SCL2 may include any one semiconductor material of InAlGaN, GaN, AlGaN, InGaN, AlN, and InN, and may include an N-type semiconductor layer doped with a second conductive dopant such as Si, Ge, or Sn. However, the material for forming the second semiconductor layer SCL2 is not limited thereto, and the second semiconductor layer SCL2 may be formed of various other materials.

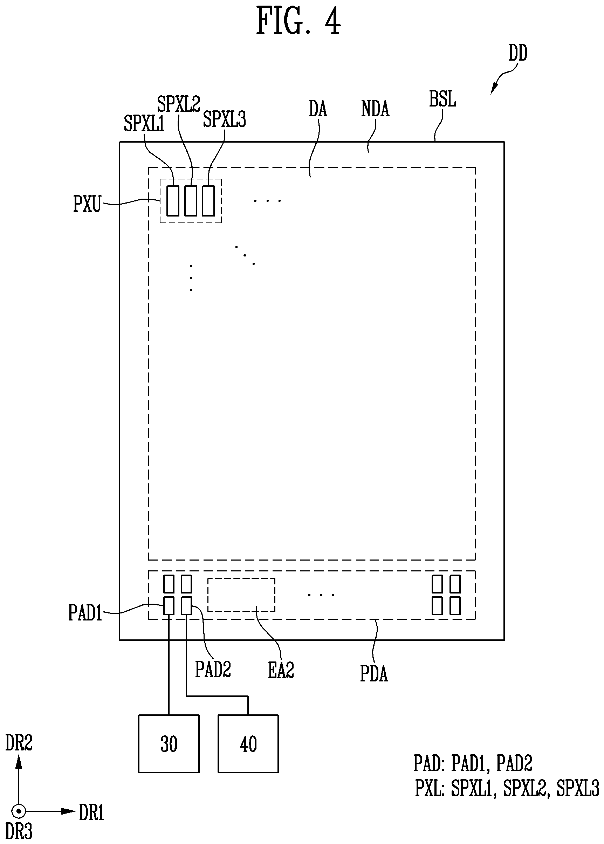

In case that a voltage equal to or greater than a threshold voltage is applied between the opposite end portions of the conductive element CE, the conductive element CE may emit light by coupling (or combination) of electron-hole pairs in the active layer AL. Since light emission of the conductive element CE is controlled based on the foregoing principle, the conductive element CE may be used as a light source of various light emitting devices as well as a pixel PXL (refer to FIG. 4) of a display device DD (refer to FIG. 3).

The element insulating layer INF may be disposed on respective surfaces of the first semiconductor layer SCL1, the second semiconductor layer SCL2, and the active layer AL. For example, the element insulating layer INF may cover at least the active layer AL, and may further enclose (or surround) an area of each of the first and second semiconductor layers SCL1 and SCL2. In one or more embodiments, the element insulating layer INF may expose the first end portion EP1 and the second end portion EP2 of the conductive element CE.

The element insulating layer INF may be formed of a single-layer structure or a double-layer structure, but embodiments are not limited thereto. The element insulating layer INF may be formed of layers. For example, the element insulating layer INF may include a first element insulating layer including a first material, and a second element insulating layer including a second material different from the first material. In one or more embodiments, the element insulating layer INF may include one or more materials selected from the group consisting of silicon oxide (SiOₓ), silicon nitride (SiNₓ), silicon oxynitride (SiOₓN_{y}), aluminum oxide (AlOₓ), and titanium oxide (TiOₓ). However, embodiments are not limited thereto.

The element insulating layer INF may contact the conductive pattern layer CO. For example, the element insulating layer INF may include a contact area which contacts the conductive pattern layer CO, and a noncontact area which does not contact the conductive pattern layer CO. For example, the first semiconductor layer SCL1, the second semiconductor layer SCL2, and the active layer AL may be (e.g., physically or electrically) spaced apart from the conductive pattern layer CO by the element insulating layer INF. The element insulating layer INF may (e.g., physically or electrically) separate the first semiconductor layer SCL1, the second semiconductor layer SCL2, and the active layer AL from the conductive pattern layer CO.

The conductive pattern layer CO may be disposed on the element insulating layer INF. The conductive pattern layer CO may overlap the element insulating layer INF. In one or more embodiments, the conductive pattern layer CO may directly contact the element insulating layer INF. The conductive pattern layer CO may expose at least a portion of the element insulating layer INF.

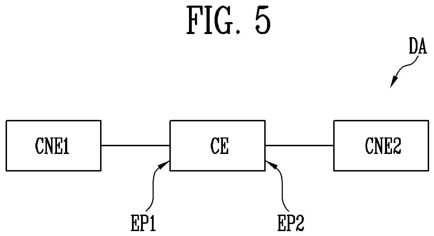

In one or more embodiments, the conductive pattern layer CO may be selectively disposed in a partial area of the element insulating layer INF, and may not be disposed in a partial area of the element insulating layer INF. For example, the conductive pattern layer CO may be physically spaced apart from the first end portion EP1 and the second end portion EP2 of the conductive element CE. The conductive pattern layer CO may be electrically insulated from a layer (e.g., the first semiconductor layer SCL1) adjacent to the first end portion EP1. The conductive pattern layer CO may be electrically insulated from a layer (e.g., the second semiconductor layer SCL2) adjacent to the second end portion EP2. For example, in case that the first end portion EP1 of the conductive element CE may be electrically connected to an electrode (e.g., a first connection electrode CNE1 in FIG. 5) for supplying an anode signal, and the second end portion EP2 of the conductive element CE is electrically connected to an electrode (e.g., a second connection electrode CNE2 in FIG. 5) for supplying a cathode signal, an electrical signal for emitting light by the conductive element CE may not be applied to the conductive pattern layer CO.

In one or more embodiments, the conductive pattern layer CO may include a conductive material. For example, the conductive pattern layer CO may include one or more materials selected from the group consisting of nickel (Ni), gold (Au), copper (Cu), and silver (Ag). However, embodiments are not limited thereto.

In one or more embodiments, the conductive pattern layer CO may form an electrical path in a cross-sectional direction of the conductive element CE (e.g., a direction different from a direction from the first end portion EP1 to the second end portion EP2). For example, a portion of a first side (e.g., an upper side in FIGS. 1 and 2) of the conductive element CE may be electrically connected to a first component adjacent to the first side. A portion of a second side (e.g., a lower side in FIGS. 1 and 2) of the conductive element CE may be electrically connected to a second component adjacent to the second side. Therefore, the first component and the second component may be electrically connected through the conductive pattern layer CO.

In one or more embodiments, the conductive pattern layer CO may form an electrical path in a direction opposite to the direction from the first end portion EP1 to the second end portion EP2. The foregoing structure of the conductive pattern layer CO may be suitable for electrically connecting two or more components to each other. For example, the conductive pattern layer CO may electrically connect a chip-on-film COF (refer to FIG. 3) to a pad PAD (refer to FIG. 4). Detailed description related thereto will be made below.

The structure of the conductive element CE is not limited thereto. For example, the conductive element CE may further include an electrode layer adjacent to the first end portion EP1 and/or the second end portion EP2. For example, the electrode layer may be an ohmic contact electrode or a Schottky contact electrode.

For example, the display device DD including the conductive element CE in accordance with one or more embodiments will be described with reference to FIGS. 3 and 4. FIG. 3 is a schematic perspective view illustrating the display device DD in accordance with one or more embodiments. FIG. 4 is a schematic plan view illustrating the display device DD in accordance with one or more embodiments.

Referring to FIG. 3 and 4, the display device DD may display images by emitting light. The display device DD may include a base layer BSL, pads PAD, and a pixel PXL. The display device DD may include a scan driver 30, a data driver 40, and a driving circuit component DCB.

The base layer BSL may form (or constitute) a base surface of the display device DD. The base layer BSL may include a rigid material or a flexible material depending on the purpose of the display device DD. The base layer BSL may include a flexible or rigid substrate or film. In one or more embodiments, the base layer BSL may be substantially transparent, or have reflexibility. However, the material of the base layer BSL that may be applied to embodiments is not limited thereto.

The display device DD (e.g., the base layer BSL) may include a display area DA and a non-display area NDA. The display area DA may be an area in which the pixel PXL is formed. The non-display area NDA may refer to an area in which the pixel PXL is not formed. Light generated from the pixel PXL may be emitted from the display area DA. In the display area DA, light may be emitted in a display direction (e.g., a third direction DR3) of the display device DD. In the non-display area NDA, light may not be emitted. The non-display area NDA may include an area other than the display area DA.

The pixel PXL may include the conductive element CE. In the display area DA, the conductive element CE may emit light, so that the pixel PXL may provide light. The pixel PXL may be disposed on the base layer BSL in the display area DA.

The pixel PXL may emit light based on a signal provided from the scan driver 30 and/or a signal provided from the data driver 40.

The pixel PXL may include a first sub-pixel SPXL1, a second sub-pixel SPXL2, and a third sub-pixel SPXL3. The pixel PXL may include a pixel unit PXU. The pixel unit PXU may be disposed in the display area DA. The pixel unit PXU may include a first sub-pixel SPXL1, a second sub-pixel SPXL2, and/or a third sub-pixel SPXL3. Hereinafter, the term "sub-pixel SPXL" or "sub-pixels SPXL" will be used to arbitrarily designate any one sub-pixel of the first sub-pixel SPXL1, the second sub-pixel SPXL2, and the third sub-pixel SPXL3, or collectively designate two or more kinds of sub-pixels.

The pixels PXL may be regularly arranged according to a stripe or PENTILE^{®} arrangement structure. The arrangement structure of the pixels PXL is not limited thereto, and the pixels PXL may be arranged in the display area DA in various structures and/or schemes.

In one or more embodiments, first sub-pixels SPXL1 that emit a first color of light, second sub-pixels SPXL2 that emit a second color of light, and third sub-pixels SPXL3 that emit a third color of light may be arranged in the display area DA. At least one first sub-pixel SPXL1, at least one second sub-pixel SPXL2, and at least one third sub-pixel SPXL3 that are disposed adjacent to each other may form one pixel unit PXU which emits various colors of light. For example, each of the first, second, and third sub-pixels SPXL1, SPXL2, and SPXL3 may be a pixel that emits a color of light. In one or more embodiments, the first sub-pixel SPXL1 may be a red pixel that emits red light, the second sub-pixel SPXL2 may be a green pixel that emits green light, and the third sub-pixel SPXL3 may be a blue pixel that emits blue light. However, embodiments are not limited thereto.

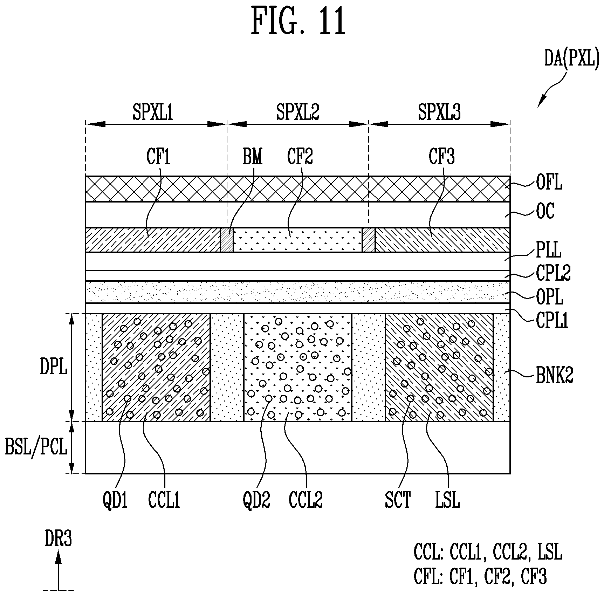

In one or more embodiments, the conductive elements CE that are respectively disposed in the first, second, and third sub-pixels SPXL1, SPXL2, and SPXL3 may emit the same color of light. For example, a color conversion layer CCL (refer to FIG. 11) and/or a color filter layer CFL (refer to FIG. 11) may be disposed on the conductive elements CE so that the first, second, and third sub-pixels SPXL1, SPXL2, and SPXL3 may emit different colors of light. In one or more embodiments, the conductive elements CE that are respectively disposed in the first, second, and third sub-pixels SPXL1, SPXL2, and SPXL3 may emit different colors of light. However, the colors, the types, and/or the number of pixels PXL that form the pixel unit PXU are not limited to specific examples.

The scan driver 30 may output a scan signal. The scan driver 30 may output a scan signal along a scan line. The data driver 40 may output (or provide) a data signal.

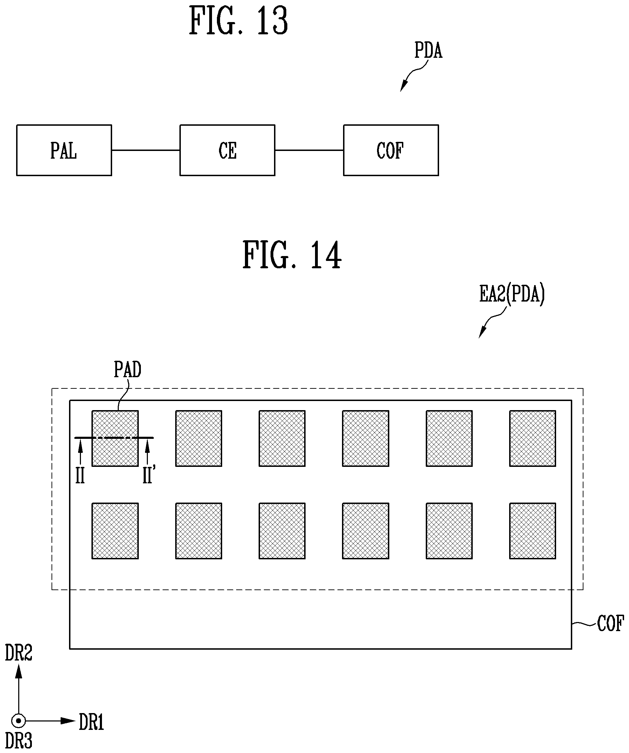

The scan driver 30 and the data driver 40 each may be connected (e.g., electrically connected) to lines of the display device DD. In one or more embodiments, the scan driver 30 and the data driver 40 may be provided (or mounted) on a flexible circuit component FPCB. Electrical signals provided from the scan driver 30 and the data driver 40 may be provided to the pixels PXL through the chip-on-film COF and the pads PAD. In one or more embodiments, the conductive element CE may electrically connect pad lines PAL (refer to FIG. 13) for forming the pads PAD to the chip-on-film COF.

Various lines, the pads (e.g., PAD), and/or internal circuits which are connected to the pixel PXL of the display area DA may be disposed in the non-display area NDA. The pad area PDA may be disposed in the non-display area NDA. The non-display area NDA may include the pad area PDA. The pad area PDA may be disposed on one side of the display area DA. Although FIGS. 3 and 4 illustrate that the pad area PDA is disposed adjacent to a lower side of the display area DA, embodiments are not limited thereto.

The pad PAD may be disposed in the pad area PDA. Pads PAD may be formed. In one or more embodiments, the pad PAD may include a first pad PAD1 and a second pad PAD2. The first pad PAD1 may be a gate pad, and the second pad PAD2 may be a data pad. The first pad PAD1 may be connected (e.g., electrically connected) to the scan driver 30. A scan signal provided from the scan driver 30 may be transmitted to a scan line for the pixel PXL via the first pad PAD1. The second pad PAD2 may be connected (e.g., electrically connected) to the data driver 40. A data signal provided from the data driver 40 may be transmitted to a data line for the pixel PXL via the second pad PAD2. The locations of the first pad PAD1 and the second pad PAD2 are not limited in the pad area PDA.

The driving circuit component DCB may include the chip-on-film COF and the flexible circuit component FPCB.

The chip-on-film COF may apply (or provide) an electrical signal generated based on a signal generated by the flexible circuit component FPCB, to a component (e.g., the pixel PXL) disposed in the display area DA. The chip-on-film COF may apply (or provide), to the pad PAD, an electrical signal based on a signal provided from the flexible circuit component FPCB. For example, the chip-on-film COF may apply (or provide), to the conductive element CE disposed in the pad area PDA, an electrical signal based on a signal provided from the flexible circuit component FPCB.

A first end portion (or a first portion) of the chip-on-film COF may be attached or connected (e.g., electrically connected) to the base layer BSL. A second end portion (or a second portion) of the chip-on-film COF may be attached or connected (e.g., electrically connected) to the flexible circuit component FPCB. At least a portion of the chip-on-film COF may be bent.

The chip-on-film COF may overlap the pad area PDA, e.g., in a plan view. For example, the first end portion (or a first portion) of the chip-on-film COF may be attached or connected (e.g., electrically connected) to the pad area PDA. In one or more embodiments, at least a portion of the chip-on-film COF may be connected (e.g., electrically connected) to the pads PAD (or the pad lines PAL) through the conductive elements CE in the pad area PDA. The first end portion (or the first portion) of the chip-on-film COF may be connected (e.g., electrically connected) to the conductive element CE in the pad area PDA. For example, an electrical signal provided from the flexible circuit component FPCB may be applied (or provided) to the pads PAD (or the pad lines PAL) through the chip-on-film COF. In one or more embodiments, a first area of the chip-on-film COF may be connected (e.g., electrically connected) to the first pad PAD1, and a second area of the chip-on-film COF may be connected (e.g., electrically connected) to the second pad PAD2.

The chip-on-film COF may include an insulating film and lines disposed on the insulating film. The chip-on-film COF may be a collective name for a structure including an insulting film formed of a thin film, and lines formed on the insulating film, and may also be referred to as a tape carrier package, a flexible printed circuit board, or the like. In the chip-on-film COF, a semiconductor chip connected to at least some of the lines may be further mounted on the insulating film.

A circuit element, which processes an electrical signal to be applied to the pixel PXL, may be disposed on the flexible circuit component FPCB. In one or more embodiments, the flexible circuit component FPCB may be a flexible circuit substrate.

The flexible circuit component FPCB may be disposed on a surface or a rear surface of the base layer BSL. An end portion of the flexible circuit component FPCB may be connected (e.g., electrically connected) to the chip-on-film COF having a curved shape and may be disposed on the rear surface of the base layer BSL, so that the flexible circuit component FPCB may be prevented from being visible to the outside.

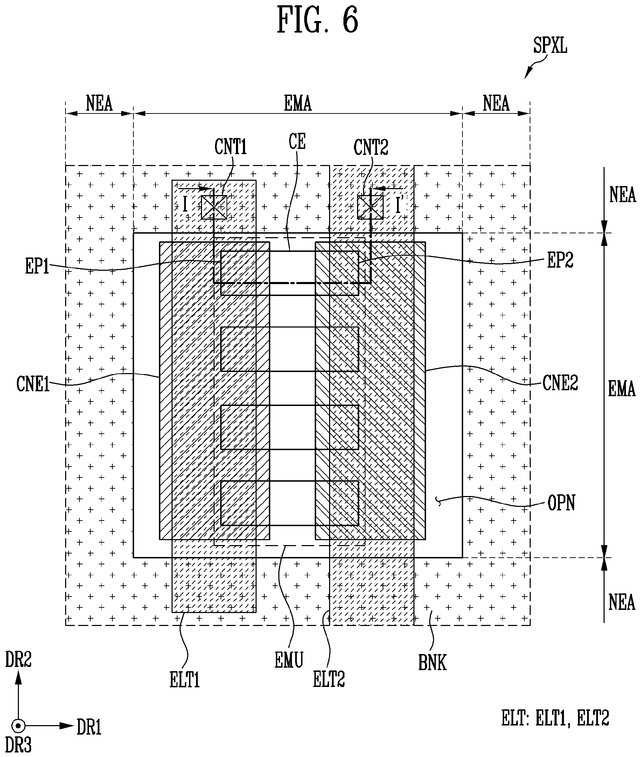

For example, the pixel PXL (e.g., the sub-pixel SPXL) in accordance with one or more embodiments will be described with reference to FIGS. 5 to 12. FIG. 5 is a schematic block diagram for describing an electrical connection structure of the conductive element CE in the display area DA in accordance with one or more embodiments. FIGS. 6 to 12 are diagrams illustrating the pixel PXL (or the sub-pixel SPXL) in accordance with one or more embodiments. Redundant description of the embodiments described above will be simplified, or may not be repeated for descriptive convenience.

Referring to FIG. 5, an electrical connection structure for allowing (or controlling) the conductive element CE to emit light will be described.

Referring to FIG. 5, in the display area DA, the conductive element CE may be connected (e.g., electrically connected) between the first connection electrode CNE1 for supplying an anode signal and the second connection electrode CNE2 for supplying a cathode signal.

In one or more embodiments, the first connection electrode CNE1 may supply an anode signal through the first end portion EP1 of the conductive element CE. The second connection electrode CNE2 may supply a cathode signal through the second end portion EP2 of the conductive element CE. For example, the conductive element CE may be a light emitting element that emits light. For example, the conductive element CE that is normally electrically connected to other lines (or electrodes) may function as a light emitting element in the display area DA.

A planar structure of the sub-pixel SPXL including the conductive element CE, which functions as a light emitting element, will be described with reference to FIG. 6. FIG. 6 is a schematic plan view illustrating the sub-pixel SPXL in accordance with one or more embodiments. The sub-pixel SPXL illustrated in FIG. 6 may be one of the first, second, and third sub-pixels SPXL1, SPXL2, and SPXL3 described above with reference to FIG. 4. In FIG. 6, there is schematically illustrated the conductive element CE, for convenience of explanation.

The sub-pixel SPXL may include an emission area EMA and a non-emission area NEA. The sub-pixel SPXL may include a bank BNK, an alignment electrode ELT, a conductive element CE, a first connection electrode CNE1, and a second connection electrode CNE2.

In a plan view, the emission area EMA may overlap an opening OPN defined by the bank BNK. Conductive elements CE may be disposed in the emission area EMA.

The conductive elements CE may not be disposed in the non-emission area NEA. A portion of the non-emission area NEA may overlap the bank BNK in a plan view.

The bank BNK may form (or provide) an opening OPN. For example, the bank BNK may have a shape protruding in a thickness direction of the base layer BSL (e.g., in a third direction DR3), and may have a shape enclosing (or surrounding) an area. For example, the opening OPN, in which the bank BNK is not disposed, may be formed.

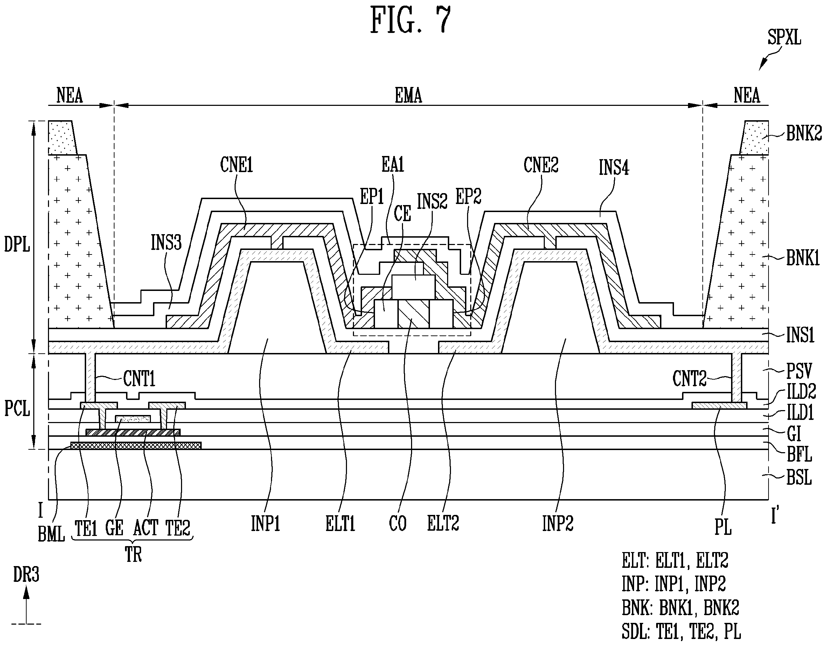

The bank BNK may form space. In a plan view, the bank BNK may have a shape enclosing (or surrounding) some areas. The space may refer to an area in which fluid is received. In one or more embodiments, the bank BNK may include a first bank (refer to 'BNK1' of FIG. 7) and a second bank (refer to 'BNK2' of FIG. 7).

In one or more embodiments, ink including the conductive elements CE may be provided to the space defined by the bank BNK (for example, the first bank BNK1), so that the conductive elements CE may be disposed in the opening OPN.

In one or more embodiments, the color conversion layer CCL may be disposed (or patterned) in the space defined by the bank BNK (e.g., the second bank BNK2).

The bank BNK may define the emission area EMA and the non-emission area NEA. In a plan view, the bank BNK may enclose (or surround) at least a portion of the emission area EMA. For example, an area where the bank BNK is disposed may correspond to (or overlap) the non-emission area NEA. As an area where the bank BNK is not disposed, an area where the conductive elements CE are disposed may correspond to (or overlap) the emission area EMA.

The alignment electrode ELT may be an electrode for aligning the conductive elements CE. In one or more embodiments, the alignment electrode ELT may include a first electrode ELT1 and a second electrode ELT2. The alignment electrode ELT may be referred to as "electrode" or "electrodes".

The alignment electrode ELT may have a single-layer structure or a multi-layer structure. For example, the alignment electrode ELT may include at least one reflective electrode layer including a reflective conductive material, and selectively further include at least one transparent electrode layer and/or a conductive capping layer. In one or more embodiments, the alignment electrode ELT may include one of silver (Ag), magnesium (Mg), aluminum (Al), platinum (Pt), palladium (Pd), gold (Au), nickel (Ni), neodymium (Nd), iridium (Ir), chrome (Cr), titanium (Ti), and an alloy thereof. However, embodiments are not limited thereto, and the alignment electrode ELT may include one of various materials having reflectivity. However, embodiments are not limited thereto.

The conductive elements CE may be disposed on the alignment electrode ELT. In one or more embodiments, at least some of the conductive elements CE may be disposed between the first electrode ELT1 and the second electrode ELT2. The conductive elements CE may be aligned between the first electrode ELT1 and the second electrode ELT2. The conductive elements CE may form (or constitute) an emission unit EMU. The emission unit EMU may refer to a unit embracing conductive elements CE adjacent to each other.

In one or more embodiments, the conductive elements CE may be aligned in various ways. For example, FIG. 6 illustrates one or more embodiments in which the conductive elements CE are aligned in parallel between the first electrode ELT1 and the second electrode ELT2. However, embodiments are not limited thereto. For example, the conductive elements CE may be aligned in series or series/parallel combination structure, and the number of units which are connected in series and/or parallel to each other is not limited to a certain number.

The first electrode ELT1 and the second electrode ELT2 may be spaced apart from each other. For example, the first electrode ELT1 and the second electrode ELT2 may be spaced apart from each other in a first direction DR1 in the emission area EMA, and each may extend in a second direction DR2.

In one or more embodiments, the first electrode ELT1 and the second electrode ELT2 may be electrodes for aligning the conductive elements CE. The first electrode ELT1 may be a first alignment electrode. The second electrode ELT2 may be a second alignment electrode.

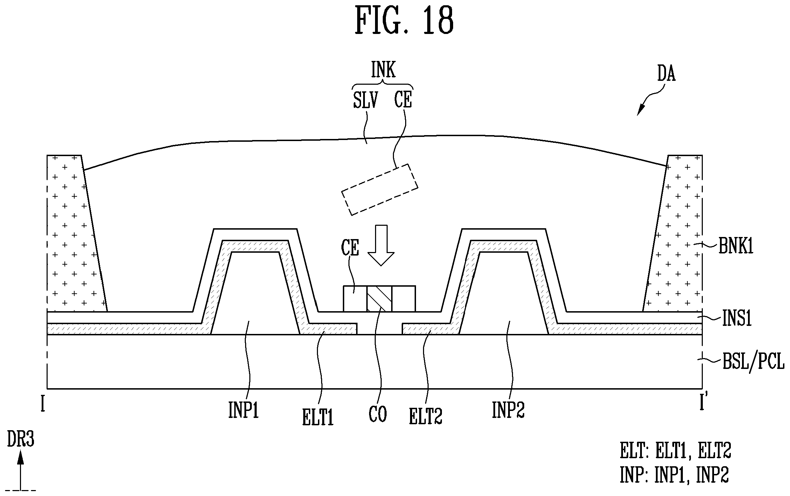

The first electrode ELT1 and the second electrode ELT2 may be respectively supplied (or provided) with a first alignment signal and a second alignment signal during a process of aligning the conductive elements CE. For example, ink INK (refer to FIG. 18) including the conductive elements CE may be supplied (or provided) to the opening OPN defined by the bank BNK (e.g., the first bank BNK1), the first alignment signal may be supplied to the first electrode ELT1, and the second alignment signal may be supplied to the second electrode ELT2. For example, the first alignment signal and the second alignment signal may have different waveforms, different potentials, and/or different phases. For example, the first alignment signal may be an AC signal, and the second alignment signal may be a ground signal. However, embodiments are not limited thereto. An electric field may be formed between (or over) the first electrode ELT1 and the second electrode ELT2, so that the conductive elements CE may be aligned between the first electrode ELT1 and the second electrode ELT2 based on the electric field. For example, the conductive elements CE may be moved (or rotated) by force, e.g., dielectrophoresis (DEP) force, derived from the electric field and thus be aligned (or disposed) on the alignment electrode ELT.

The first electrode ELT1 may be electrically connected to a circuit element, e.g., a transistor TR (refer to FIG. 7), through a first contactor CNT1. In one or more embodiments, the first electrode ELT1 may provide an anode signal for the conductive element CE to emit light. The first electrode ELT1 may provide a first alignment signal to align the conductive element CE.

The second electrode ELT2 may be connected (e.g., electrically connected) to a power line PL (refer to FIG. 7) through a second contactor CNT2. In one or more embodiments, the second electrode ELT2 may provide a cathode signal for the conductive element CE to emit light. The second electrode ELT2 may provide a second alignment signal to align the conductive element CE.

The positions of the first contactor CNT1 and the second contactor CNT2 are not limited to the positions illustrated in FIG. 6, and may be appropriately changed in various ways.

The conductive element CE may emit light based on a provided electrical signal. For example, the conductive element CE may provide light based on a first electrical signal (for example, an anode signal) provided from the first connection electrode CNE1 and a second electrical signal (for example, a cathode signal) provided from the second connection electrode CNE2.

The first end portion EP1 of the conductive element CE may be disposed adjacent to the first electrode ELT1. The second end portion EP2 of the conductive element CE may be disposed adjacent to the second electrode ELT2. The first end portion EP1 may or may not overlap the first electrode ELT1. The second end portion EP2 may or may not overlap the second electrode ELT2.

In one or more embodiments, the respective first end portions EP1 of the conductive elements CE may be connected (e.g., electrically connected) to the first electrode ELT1 through the first connection electrode CNE1. In one or more embodiments, the respective first end portions EP1 of the conductive elements CE may be directly connected to the first electrode ELT1. In one or more embodiments, the respective first end portions EP1 of the conductive elements CE may be connected (e.g., electrically connected) to only the first connection electrode CNE1, rather than being connected to the first electrode ELT1.

For example, the respective second end portions EP2 of the conductive element CE may be electrically connected to the second electrode ELT2 through the second connection electrode CNE2. In one or more embodiments, the respective second end portions EP2 of the conductive elements CE may be directly connected to the second electrode ELT2. In one or more embodiments, the respective second end portions EP2 of the conductive elements CE may be connected (e.g., electrically connected) to only the second connection electrode CNE2, rather than being connected to the second electrode ELT2.

The first connection electrode CNE1 and the second connection electrode CNE2 may be respectively disposed on the first end portions EP1 and the second end portions EP2 of the conductive elements CE.

The first connection electrode CNE1 may be disposed on the first end portions EP1 of the conductive elements CE such that the first connection electrode CNE1 may be connected (e.g., electrically connected) to the first end portions EP1. In one or more embodiments, the first connection electrode CNE1 may be disposed on the first electrode ELT1 and connected (e.g., electrically connected) with the first electrode ELT1. For example, the first end portions EP1 of the conductive elements CE may be electrically connected to the first electrode ELT1 through the first connection electrode CNE1.

The second connection electrode CNE2 may be disposed on the second end portions EP2 of the conductive elements CE such that the second connection electrode CNE2 may be connected (e.g., electrically connected) to the second end portions EP2. In one or more embodiments, the second connection electrode CNE2 may be disposed on the second electrode ELT2 and connected (e.g., electrically connected) to the second electrode ELT2. For example, the second end portions EP2 of the conductive elements CE may be electrically connected to the second electrode ELT2 through the second connection electrode CNE2.

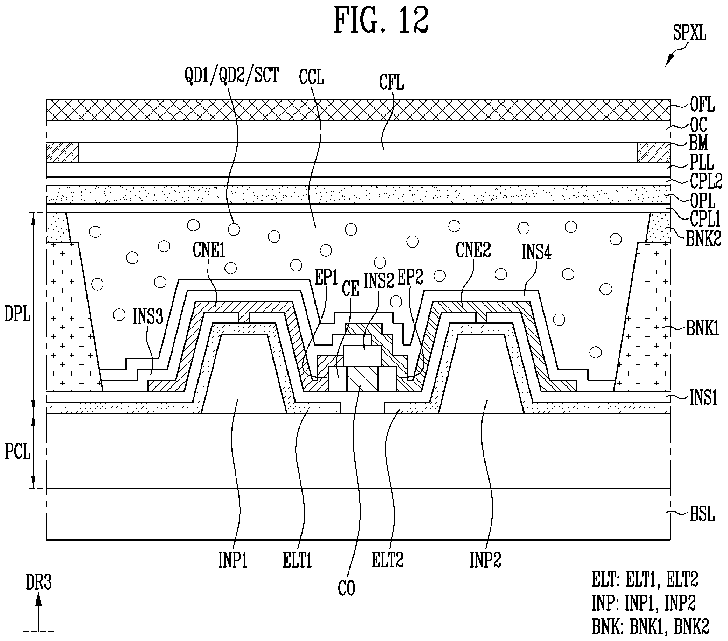

For example, a cross-sectional structure of the pixel PXL (or the sub-pixel SPXL) in accordance with one or more embodiments will be described with reference to FIGS. 7 to 12. For example, the pixel circuit layer PCL and the display element layer DPL of the sub-pixel SPXL will be described with reference to FIGS. 7 to 10. An optical layer OPL, a color filter layer CFL, and an outer film layer OFL will be described with reference to FIGS. 11 and 12. Redundant description that of the embodiments described above will be simplified, or may not be repeated for descriptive convenience.

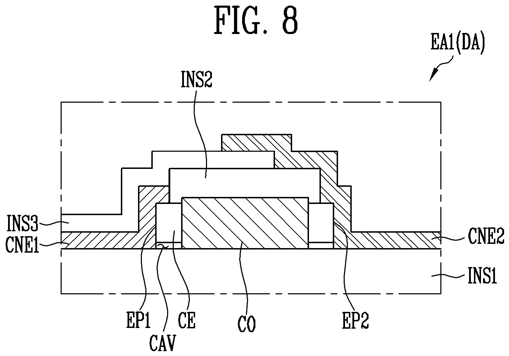

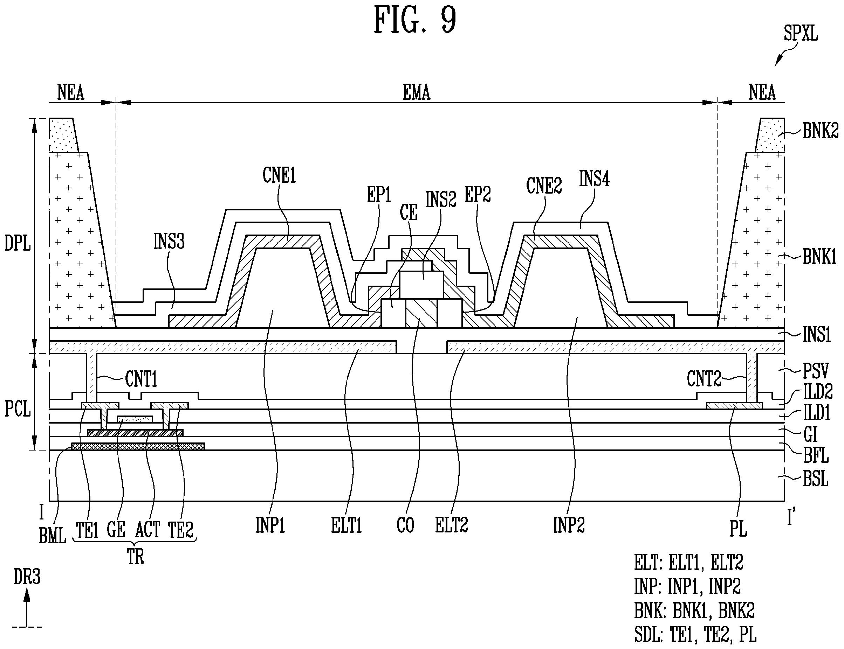

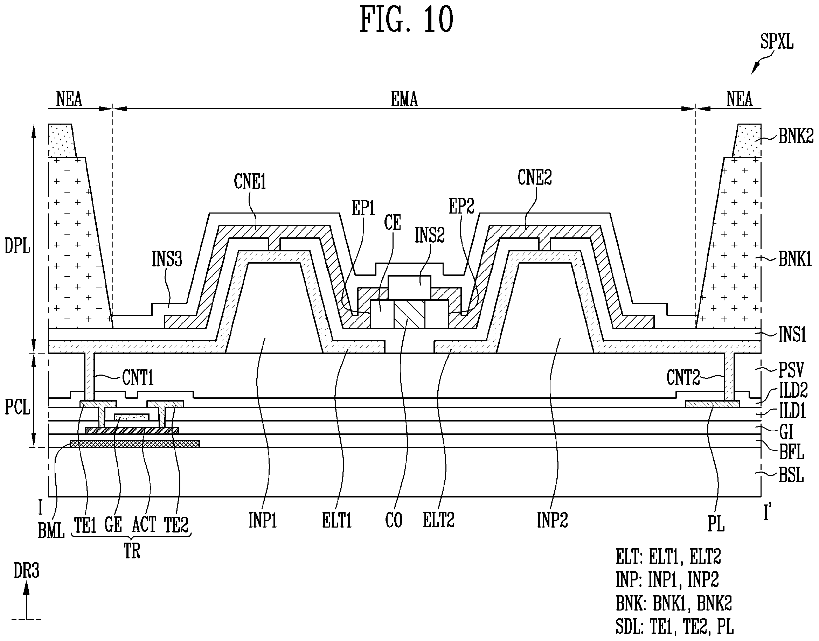

FIGS. 7 to 10 are schematic sectional views each illustrating a sub-pixel SPXL in accordance with one or more embodiments. For example, FIGS. 7, 9, and 10 are schematic sectional views taken along line I-I' of FIG. 6. FIG. 7 is a schematic sectional view illustrating a sub-pixel SPXL in accordance with a first embodiment. FIG. 8 is a schematic enlarged view of area EA1 of FIG. 7. FIG. 9 is a schematic sectional view illustrating a sub-pixel SPXL in accordance with a second embodiment. FIG. 10 is a schematic sectional view illustrating a sub-pixel SPXL in accordance with a third embodiment. For convenience of explanation, FIGS. 7, 9, and 10 each schematically illustrate a conductive element CE, and a detailed connection structure of the conductive element CE in a display element layer DPL will be understood with reference to FIG. 8. FIG. 11 is a schematic sectional view illustrating a pixel PXL in accordance with one or more embodiments. FIG. 12 is a schematic sectional view illustrating a sub-pixel SPXL in accordance with one or more embodiments.

For example, the sub-pixel SPXL in accordance with the first embodiment will be described with reference to FIG. 7. Referring to FIG. 7, the sub-pixel SPXL may be disposed on the base layer BSL. The sub-pixel SPXL may include a pixel circuit layer PCL and a display element layer DPL.

The base layer BSL may form a base for forming the sub-pixel SPXL. The base layer BSL may provide an area formed to dispose the pixel circuit layer PCL and the display element layer DPL therein.

The pixel circuit layer PCL may be disposed on the base layer BSL. The pixel circuit layer PCL may include an auxiliary bottom electrode BML, a buffer layer BFL, a transistor TR, a gate insulating layer GI, a first interlayer insulating layer ILD1, a second interlayer insulating layer ILD2, and a passivation layer PSV.

The auxiliary bottom electrode BML may be disposed on the base layer BSL. The auxiliary bottom electrode BML may function as a path along which an electrical signal is transmitted. In one or more embodiments, a portion of the auxiliary bottom electrode BML may overlap the transistor TR, e.g., in a plan view.

The buffer layer BFL may be disposed on the base layer BSL. The buffer layer BFL may cover the auxiliary bottom electrode BML. The buffer layer BFL may prevent impurities from diffusing or permeating from the outside. The buffer layer BFL may include one of silicon oxide (SiOₓ), silicon nitride (SiNₓ), silicon oxynitride (SiOₓN_{y}), aluminum oxide (AlOₓ), and titanium oxide (TiOₓ). However, embodiments are not limited thereto.

The transistor TR may be a thin film transistor. In one or more embodiments, the transistor TR may be a driving transistor. The transistor TR may be electrically connected to the conductive element CE. The transistor TR may be electrically connected to the first end portion EP1 of the conductive element CE.

The transistor TR may include an active layer ACT, a first transistor electrode TE1, a second transistor electrode TE2, and a gate electrode GE.

The active layer ACT may refer to a semiconductor layer. The active layer ACT may be disposed on the buffer layer BFL. The active layer ACT may include one selected from the group consisting of polysilicon, low temperature polycrystalline silicon (LTPS), amorphous silicon, and an oxide semiconductor.

The active layer ACT may include a first contact area which contacts the first transistor electrode TE1, and a second contact area which contacts the second transistor electrode TE2. Each of the first contact area and the second contact area may be a semiconductor pattern layer doped with an impurity. An area between the first contact area and the second contact area may be a channel area. The channel area may be an intrinsic semiconductor pattern layer which is not doped with an impurity.

The gate electrode GE may be disposed on the gate insulating layer GI. The position of the gate electrode GE may correspond to the position of the channel area of the active layer ACT. For example, the gate electrode GE may be disposed on the channel area of the active layer ACT with the gate insulating layer GI disposed therebetween.

The gate insulating layer GI may be disposed on the buffer layer BFL. The gate insulating layer GI may cover the active layer ACT. The gate insulating layer GI may include one of silicon oxide (SiOₓ), silicon nitride (SiNₓ), silicon oxynitride (SiOₓN_{y}), aluminum oxide (AlOₓ), and titanium oxide (TiOₓ). However, embodiments are not limited thereto.

The first interlayer insulating layer ILD1 may be disposed on the gate insulating layer GI. The first interlayer insulating layer ILD1 may cover the gate electrode GE. The first interlayer insulating layer ILD1 may include one of silicon oxide (SiOₓ), silicon nitride (SiNₓ), silicon oxynitride (SiOₓN_{y}), aluminum oxide (AlOₓ), and titanium oxide (TiOₓ). However, embodiments are not limited thereto.

The first transistor electrode TE1 and the second transistor electrode TE2 may be disposed on the first interlayer insulating layer ILD1. The first transistor electrode TE1 may contact the first contact area of the active layer ACT through the gate insulating layer GI and the first interlayer insulating layer ILD1. The second transistor electrode TE2 may contact the second contact area of the active layer ACT through the gate insulating layer GI and the first interlayer insulating layer ILD1. For example, the first transistor electrode TE1 may be a drain electrode, and the second transistor electrode TE2 may be a source electrode, but embodiments are not limited thereto.

The first transistor electrode TE1 may be electrically connected to the first electrode ELT1 through the first contactor CNT1 passing through the passivation layer PSV and the second interlayer insulating layer ILD2.

The power line PL may be disposed on the first interlayer insulating layer ILD1. In one or more embodiments, the power line PL, the first transistor electrode TE1, and the second transistor electrode TE2 may be disposed in the same layer or may be formed of the same layer (or the same material). The power line PL may be connected (e.g., electrically connected) to the second electrode ELT2 through the second contactor CNT2. The power line PL may supply power or an alignment signal through the second electrode ELT2.

In one or more embodiments, a layer in which the first transistor electrode TE1, the second transistor electrode TE2, and the power line PL are disposed may be a source/drain layer SDL. The source/drain layer SDL may include layers, which are disposed in the same layer or are formed of the same layer (or the same material). For example, the source/drain layer SDL may include the first transistor electrode TE1, the second transistor electrode TE2, and the power line PL.

The second interlayer insulating layer ILD2 may be disposed on the first interlayer insulating layer ILD1. The second interlayer insulating layer ILD2 may cover the first transistor electrode TE1, the second transistor electrode TE2, and the power line PL. The second interlayer insulating layer ILD2 may include one of silicon oxide (SiOₓ), silicon nitride (SiNₓ), silicon oxynitride (SiOₓN_{y}), aluminum oxide (AlOₓ), and titanium oxide (TiOₓ). However, embodiments are not limited thereto.

The passivation layer PSV may be disposed on the second interlayer insulating layer ILD2. In embodiments, the passivation layer PSV may be a via layer. The passivation layer PSV may include an organic material for planarizing a stepped structure formed therebelow. For example, the passivation layer PSV may include an organic material such as acrylic resin, epoxy resin, phenol resin, polyamide resin, polyimide resin, polyester resin, polyphenylene sulfide resin, or benzocyclobutene (BCB). However, embodiments are not limited thereto. The passivation layer PSV may include various inorganic materials including silicon oxide (SiOₓ), silicon nitride (SiNₓ), silicon oxynitride (SiOₓN_{y}), aluminum nitride (AlNₓ), aluminum oxide (AlOₓ), zirconium oxide (ZrOₓ), hafnium oxide (HfOₓ), and titanium oxide (TiOₓ).

In one or more embodiments, the sub-pixel SPXL may include a first contactor CNT1 and a second contactor CNT2. The first contactor CNT1 and the second contactor CNT2 each may pass through the second interlayer insulating layer ILD2 and the passivation layer PSV. The first electrode ELT1 and the first transistor electrode TE1 may be electrically connected to each other through the first contactor CNT1. The second electrode ELT2 and the power line PL may be electrically connected to each other through the second contactor CNT2.

The display element layer DPL may be disposed on the pixel circuit layer PCL. The display element layer DPL may include a first insulating layer INS1, an insulating pattern layer INP, an alignment electrode ELT, a bank BNK, a conductive element CE, a second insulating layer INS2, a first connection electrode CNE1, a third insulating layer INS3, a second connection electrode CNE2, and a fourth insulating layer INS4.

The insulating pattern layer INP may be disposed on the passivation layer PSV. In another example, the insulating pattern layer INP may have various shapes. In one or more embodiments, the insulating pattern layer INP may protrude in a thickness direction of the base layer BSL (e.g., in the third direction DR3). Furthermore, the insulating pattern layer INP may have an inclined surface which is inclined at an angle with respect to the base layer BSL. However, embodiments are not limited thereto. The insulating pattern layer INP may have a sidewall having a curved shape or a stepped shape. For example, the insulating pattern layer INP may have a cross-sectional shape such as a semi-circular shape or a semi-elliptical shape.

The insulating pattern layer INP may function to form a step difference so that the conductive elements CE may be readily aligned in the emission area. In one or more embodiments, the insulating pattern layer INP may be a partition wall.

In one or more embodiments, a portion of the alignment electrode ELT may be disposed on the insulating pattern layer INP. For example, the insulating pattern layer INP may include a first insulating pattern layer INP1 and a second insulating pattern layer INP2. The first electrode ELT1 may be disposed on the first insulating pattern layer INP1. The second electrode ELT2 may be disposed on the second insulating pattern layer INP2. For example, a reflective wall may be formed on the insulating pattern layer INP. Accordingly, light emitted from the conductive element CE may be recycled or reused, so that the light output efficiency of the display device DD (or the pixel PXL) may be improved.

The insulating pattern layer INP may include at least one organic material and/or inorganic material. For example, the insulating pattern layer INP may include an organic material such as acrylic resin, epoxy resin, phenol resin, polyamide resin, polyimide resin, polyester resin, polyphenylene sulfide resin, or benzocyclobutene (BCB). However, embodiments are not limited thereto. The insulating pattern layer INP may include various inorganic materials including silicon oxide (SiOₓ), silicon nitride (SiNₓ), silicon oxynitride (SiOₓN_{y}), aluminum nitride (AlNₓ), aluminum oxide (AlOₓ), zirconium oxide (ZrOₓ), hafnium oxide (HfOₓ), or titanium oxide (TiOₓ).

The alignment electrode ELT may be disposed on the passivation layer PSV and/or the insulating pattern layer INP. As described above, a portion of the alignment electrode ELT may be disposed on the insulating pattern layer INP such that a reflective wall may be formed. Alignment signals (e.g., an AC signal and a ground signal) for aligning the conductive element CE may be supplied to the alignment electrodes ELT. In one or more embodiments, electrical signals (e.g., an anode signal and a cathode signal) may be supplied to the alignment electrodes ELT to allow the conductive element CE to emit light.

In one or more embodiments, the alignment electrode ELT may be disposed on a rear surface of the first insulating layer INS1. For example, the alignment electrode ELT may be disposed between the first insulating layer INS1 and the insulating pattern layer INP or the passivation layer PSV. For example, a surface of the alignment electrode ELT may contact the first insulating layer INS1.

The first electrode ELT1 may be connected (e.g., electrically connected) to the conductive element CE. The first electrode ELT1 may be electrically connected to the first connection electrode CNE1 through a contact hole formed in the first insulating layer INS1. The first electrode ELT1 may provide an anode signal for the conductive element CE to emit light.

The second electrode ELT2 may be connected (e.g., electrically connected) to the conductive element CE. The second electrode ELT2 may be connected (e.g., electrically connected) to the second connection electrode CNE2 through a contact hole formed in the first insulating layer INS1. The second electrode ELT2 may provide a cathode signal (e.g., a ground signal) for the conductive element CE to emit light.

The first insulating layer INS1 may be disposed on the alignment electrode ELT. For example, the first insulating layer INS1 may cover the first electrode ELT1 and the second electrode ELT2.

The bank BNK may be disposed on the first insulating layer INS1. In one or more embodiments, the bank BNK may include a first bank BNK1 and a second bank BNK2.

The first bank BNK1 may be disposed on the first insulating layer INS1. In one or more embodiments, e.g., in a plan view, the first bank BNK1 may not overlap the emission area EMA, and may overlap the non-emission area NEA. As described above, the first bank BNK1 may protrude in the thickness direction of the base layer BSL (e.g., in the third direction DR3), so that the first bank BNK1 may define an opening OPN. Space to which the conductive elements CE may be provided during a process of supplying the conductive elements CE may be formed in the opening OPN.

The first bank BNK1 may include an organic material such as acrylic resin, epoxy resin, phenol resin, polyamide resin, polyimide resin, polyester resin, polyphenylene sulfide resin, or benzocyclobutene (BCB). However, embodiments are not limited thereto. The first bank BNK1 may include various inorganic materials including silicon oxide (SiOₓ), silicon nitride (SiNₓ), silicon oxynitride (SiOₓN_{y}), aluminum nitride (AlNₓ), aluminum oxide (AlOₓ), zirconium oxide (ZrOₓ), hafnium oxide (HfOₓ), and titanium oxide (TiOₓ).

The second bank BNK2 may be disposed on the first bank BNK1. The second bank BNK2 may protrude in the thickness direction of the base layer BSL (e.g., in the third direction DR3), so that the second bank BNK2 may define an opening OPN. Space to which the color conversion layer CCL is to be provided may be formed in the opening OPN.

The second bank BNK2 may include an organic material such as acryl resin, epoxy resin, phenol resin, polyamide resin, polyimide resin, polyester resin, polyphenylene sulfide resin, or benzocyclobutene (BCB). However, embodiments are not limited thereto. The second bank BNK2 may include various inorganic materials including silicon oxide (SiOₓ), silicon nitride (SiNₓ), silicon oxynitride (SiOₓN_{y}), aluminum nitride (AlNₓ), aluminum oxide (AlOₓ), zirconium oxide (ZrOₓ), hafnium oxide (HfOₓ), and titanium oxide (TiOₓ).

The conductive element CE may be disposed on the first insulating layer INS1. In one or more embodiments, the conductive element CE may emit light based on electrical signals (e.g., an anode signal and a cathode signal) provided from the first connection electrode CNE1 and the second connection electrode CNE2.

The conductive element CE may be disposed in an area enclosed (or surrounded) by the first bank BNK1. The conductive element CE may be disposed between the first insulating pattern layer INP1 and the second insulating pattern layer INP2.

The second insulating layer INS2 may be disposed on the conductive element CE. The second insulating layer INS2 may cover the active layer AL of the conductive element CE.

The second insulating layer INS2 may expose at least a portion of the conductive element CE. For example, the second insulating layer INS2 may not cover the first end portion EP1 and the second end portion EP2 of the conductive element CE. For example, the first end portion EP1 and the second end portion EP2 of the conductive element CE may be exposed and respectively connected (e.g., electrically connected) to the first connection electrode CNE1 and the second connection electrode CNE2.

In case that the second insulating layer INS2 is formed on the conductive elements CE after the alignment of the conductive elements CE is completed, the conductive elements CE may be prevented from being removed from the aligned positions.

The second insulating layer INS2 may have a single-layer structure or a multi-layer structure. The second insulating layer INS2 may include various inorganic materials including silicon oxide (SiOₓ), silicon nitride (SiNₓ), silicon oxynitride (SiOₓN_{y}), aluminum nitride (AlNₓ), aluminum oxide (AlOₓ), zirconium oxide (ZrOₓ), hafnium oxide (HfOₓ), and titanium oxide (TiOₓ). However, embodiments are not limited thereto.

The first connection electrode CNE1 and the second connection electrode CNE2 may be disposed on the first insulating layer INS1. The first connection electrode CNE1 may be connected (e.g., electrically connected) to the first end portion EP1 of the conductive element CE. The second connection electrode CNE2 may be connected (e.g., electrically connected) to the second end portion EP2 of the conductive element CE.

The first connection electrode CNE1 may be connected (e.g., electrically connected) to the first electrode ELT1 through a contact hole passing through the first insulating layer INS1. The second connection electrode CNE2 may be connected (e.g., electrically connected) to the second electrode ELT2 through a contact hole passing through the first insulating layer INS1.

The first connection electrode CNE1 and the second connection electrode CNE2 may include a conductive material. For example, the first connection electrode CNE1 and the second connection electrode CNE2 may include a transparent conductive material including one of indium tin oxide (ITO), indium zinc oxide (IZO), and indium tin zinc oxide (ITZO). For example, light emitted from the conductive elements CE may be emitted out of the display device DD after passing through the first and second connection electrodes CNE1 and CNE2. However, embodiments are not limited thereto.

In one or more embodiments, after any one of the first connection electrode CNE1 and the second connection electrode CNE2 is patterned, the other electrode may be patterned. However, embodiments are not limited thereto.

The third insulating layer INS3 may be disposed on the first insulating layer INS1 and the first connection electrode CNE1. At least a portion of the third insulating layer INS3 may be disposed between the first connection electrode CNE1 and the second connection electrode CNE2, so that a short-circuit defect between the first connection electrode CNE1 and the second connection electrode CNE2 may be prevented from occurring.

The fourth insulating layer INS4 may be disposed on the third insulating layer INS3 and the second connection electrode CNE2. The fourth insulating layer INS4 may protect the components of the display element layer DPL from external effects.

The third insulating layer INS3 and the fourth insulating layer INS4 each may have a single-layer structure or a multi-layer structure. The third insulating layer INS3 and the fourth insulating layer INS4 each may include various inorganic materials including silicon oxide (SiOₓ), silicon nitride (SiNₓ), silicon oxynitride (SiOₓN_{y}), aluminum nitride (AlNₓ), aluminum oxide (AlOₓ), zirconium oxide (ZrOₓ), hafnium oxide (HfOₓ), and titanium oxide (TiOₓ).

For example, a connection structure adjacent to the conductive element CE will be described. Redundant description of the embodiments described above will be simplified, or may not be repeated for descriptive convenience.

Referring to FIG. 8, the first end portion EP1 of the conductive element CE may be connected (e.g., electrically connected) to the first connection electrode CNE1 without physically contacting the second connection electrode CNE2. The second end portion EP2 of the conductive element CE may be connected (e.g., electrically connected) to the second connection electrode CNE2 without physically contacting the first connection electrode CNE1. The first connection electrode CNE1 may be physically spaced apart from the conductive pattern layer CO. The second connection electrode CNE2 may be physically spaced apart from the conductive pattern layer CO.

In one or more embodiments, the second insulating layer INS2 may overlap (e.g., entirely overlap) the conductive pattern layer CO. For example, the second insulating layer INS2 may cover (e.g., entirely cover) the conductive pattern layer CO, e.g., in a plan view. A portion of the second insulating layer INS2 may overlap the conductive pattern layer CO, e.g., in a plan view. Another portion of the second insulating layer INS2 may not overlap the conductive pattern layer CO, e.g., in a plan view. For example, the second insulating layer INS2 may enclose or surround (e.g., entirely enclose or surround) the conductive pattern layer CO formed on an outer surface of the element insulating layer INF. For example, the first connection electrode CNE1 or the second connection electrode CNE2 may be prevented from being brought into physical contact with and connected (e.g., electrically connected) to the conductive pattern layer CO.

In one or more embodiments, the conductive element CE disposed on the first insulating layer INS1 may form a cavity (or empty space) CAV in an area where the conductive pattern layer CO is not disposed. For example, the conductive pattern layer CO having a thickness may be disposed on the outer surface of the element insulating layer INF on the outer side surface of the conductive element CE. Thereby, in an area of the conductive element CE where the conductive pattern layer CO is not disposed, a step difference may be formed. In one or more embodiments, a surface of the conductive element CE on which the conductive pattern layer CO is not patterned may be spaced apart from the first insulating layer INS1.

For example, the sub-pixel SPXL in accordance with the second embodiment will be described with reference to FIG. 9. Redundant description of the embodiments described above will be simplified, or may not be repeated for descriptive convenience.

The sub-pixel SPXL in accordance with the second embodiment is different from the sub-pixel SPXL in accordance with the first embodiment in that the alignment electrodes ELT are disposed below the insulating pattern layer INP.

In accordance with the second embodiment, the alignment electrodes ELT may be disposed on the passivation layer PSV. The insulating pattern layer INP may be disposed on the first insulating layer INS1 that covers the alignment electrodes ELT. For example, the alignment electrodes ELT may be more adjacent to the base layer BSL than the insulating pattern layer INP is adjacent to the base layer BSL. For example, a distance between the alignment electrodes ELT and the base layer BSL in the third direction DR3 may be smaller than a distance between the insulating pattern layer INP and the base layer BSL in the third direction DR3. In one or more embodiments, the alignment electrodes ELT may contact (e.g., directly contact) the passivation layer PSV.

In accordance with the second embodiment, the alignment electrodes ELT may be patterned to have an overall planar shape along a top surface (or upper surface) of the passivation layer PSV. For example, the degree of alignment of the conductive element CE may be improved.

For example, the sub-pixel SPXL in accordance with the third embodiment will be described with reference to FIG. 10. Redundant description of the embodiments described above will be simplified, or may not be repeated for descriptive convenience.

The sub-pixel SPXL in accordance with the third embodiment is different from the sub-pixel SPXL in accordance with the first embodiment in that the first connection electrode CNE1 and the second connection electrode CNE2 are patterned by the same process.

In accordance with the third embodiment, the first connection electrode CNE1 and the second connection electrode CNE2 may be disposed in the same layer or may be formed of the same layer. For example, the first connection electrode CNE1 and the second connection electrode CNE2 may include the same material. For example, the first connection electrode CNE1 and the second connection electrode CNE2 may be respectively connected (e.g., electrically connected) to the first end portion EP1 and the second end portion EP2 of the conductive element CE. In accordance with the third embodiment, process steps may be simplified, so that the cost of the process may be reduced.

For example, the components of the pixel PXL including a color conversion layer CCL will be described with reference to FIGS. 11 and 12. FIG. 11 illustrates the color conversion layer CCL, an optical layer OPL, a color filter layer CFL, and the like. For convenience of description, in FIG. 11, among the above-mentioned components, the components of the pixel circuit layer PCL and the components of the display element layer DPL other than the second bank BNK2 will be omitted. FIG. 12 illustrates a stacked structure of the pixel PXL with regard to the color conversion layer CCL, the optical layer OPL, and the color filter layer CFL.

Referring to FIGS. 11 and 12, the second bank BNK2 may be disposed between the first, second, and third sub-pixels SPXL1, SPXL2, and SPXL3 or on boundary areas therebetween, and define space (or areas) which respectively overlap the first, second, and third sub-pixels SPXL1, SPXL2, and SPXL3. The space defined by the second bank BNK2 may be an area in which the color conversion layer CCL may be provided.

The color conversion layer CCL may be disposed on the conductive elements CE in the space enclosed (or surrounded) by the second bank BNK2. The color conversion layer CCL may include a first color conversion layer CCL1 disposed in the first sub-pixel SPXL1, a second color conversion layer CCL2 disposed in the second sub-pixel SPXL2, and a light scattering layer LSL disposed in the third sub-pixel SPXL3.

The color conversion layer CCL may be disposed on the conductive element CE. The color conversion layer CCL may be formed to change (or convert) the wavelength of light. In one or more embodiments, the first, second, and third sub-pixels SPXL1, SPXL2, and SPXL3 may include conductive elements CE that emit the same color of light. For example, the first, second, and third sub-pixels SPXL1, SPXL2, and SPXL3 may include conductive elements CE that emit the third color of light (or blue light). As the color conversion layer CCL including color conversion particles is disposed in each of the first, second, and third sub-pixels SPXL1, SPXL2, and SPXL3, a full-color image may be displayed.

The first color conversion layer CCL1 may include first color conversion particles for converting the third color of light emitted from the conductive element CE to the first color of light. For example, the first color conversion layer CCL1 may include first quantum dots QD1 which are dispersed in a matrix material such as base resin.

In one or more embodiments, in case that the conductive element CE is a blue light emitting element that emits blue light and the first sub-pixel SPXL1 is a red pixel, the first color conversion layer CCL1 may include the first quantum dots QD1 which convert blue light emitted from the blue light emitting element to red light. The first quantum dots QD1 may absorb blue light, shift the wavelength thereof according to an energy transition, and may emit red light. In case that the first sub-pixel SPXL1 is one of pixels of other colors, the first color conversion layer CCL1 may include the first quantum dots QD1 corresponding to the color of the first sub-pixel SPXL1.

The second color conversion layer CCL2 may include second color conversion particles for converting the third color of light emitted from the conductive element CE to the second color of light. For example, the second color conversion layer CCL2 may include second quantum dots QD2 which are dispersed in a matrix material such as base resin.

In one or more embodiments, in case that the conductive element CE is a blue light emitting element that emits blue light and the second sub-pixel SPXL2 is a green pixel, the second color conversion layer CCL2 may include the second quantum dots QD2 which convert blue light emitted from the blue light emitting element to green light. The second quantum dots QD2 may absorb blue light, shift the wavelength thereof according to an energy transition, and may emit green light. In case that the second sub-pixel SPXL2 is one of pixels of other colors, the second color conversion layer CCL2 may include the second quantum dots QD2 corresponding to the color of the second sub-pixel SPXL2.

In one or more embodiments, as blue light having a relatively short wavelength in a visible ray area is incident on each of the first quantum dots QD1 and the second quantum dots QD2, absorption coefficients of the first quantum dot QD1 and the second quantum dot QD2 may be increased. Therefore, the efficiency of light emitted from the first sub-pixel SPXL1 and the second sub-pixel SPXL2 may be enhanced, and satisfactory color reproducibility may be secured. Furthermore, as the emission unit EMU for the first, second, and third sub-pixels SPXL1, SPXL2, and SPXL3 is formed of conductive elements CE (e.g., blue light emitting elements) that emit the same color of light, the efficiency of fabricating the display device DD may be enhanced.

The light scattering layer LSL may be formed to efficiently use the third color of light (or blue light) emitted from the conductive element CE. For example, in case that the conductive elements CE is a blue light emitting element that emits blue light and the third sub-pixel SPXL3 is a blue pixel, the light scattering layer LSL may include at least one type of light scatterer SCT to efficiently use light emitted from the conductive elements CE. For example, the light scatterer SCT of the light scattering layer LSL may include at least one of barium sulfate (BaSO₄), calcium carbonate (CaCO₃), titanium oxide (TiO₂), silicon oxide (SiO₂), aluminum oxide (Al₂O₃), zirconium oxide (ZrO₂), and zinc oxide (ZnO). The light scatterers SCT may not only be disposed in the third sub-pixel SPXL3, but may also be selectively included in the first color conversion layer CCL1 or the second color conversion layer CCL2. In one or more embodiments, the light scatterers SCT may be omitted, and the light scattering layer LSL may be formed of transparent polymer.

A first capping layer CPL1 may be disposed on the color conversion layer CCL. The first capping layer CPL1 may be disposed over the first, second, and third sub-pixels SPXL1, SPXL2, and SPXL3. The first capping layer CPL1 may cover the color conversion layer CCL. The first capping layer CPL1 may prevent the color conversion layer CCL from being damaged or contaminated by permeation of external impurities such as water or air.

The first capping layer CPL1 may be an inorganic layer, and be formed of silicon nitride (SiNₓ), aluminum nitride (AlNₓ), titanium nitride (TiNₓ), silicon oxide (SiOₓ), aluminum oxide (AlOₓ), titanium oxide (TiOₓ), silicon oxycarbide (SiOₓC_{y}), or silicon oxynitride (SiOₓN_{y}).

The optical layer OPL may be disposed on the first capping layer CPL1. The optical layer OPL may function to recycle light provided from the color conversion layer CCL by reflection (e.g., total reflection) and may enhance light extraction efficiency. For example, the optical layer OPL may have a relatively lower refractive index compared to that of the color conversion layer CCL. For example, the refractive index of the color conversion layer CCL may be approximately in a range of about 1.6 to about 2.0, and the refractive index of the optical layer OPL may be approximately in a range of about 1.1 to about 1.3.

A second capping layer CPL2 may be disposed on the optical layer OPL. The second capping layer CPL2 may be disposed over the first, second, and third sub-pixels SPXL1, SPXL2, and SPXL3. The second capping layer CPL2 may cover the optical layer OPL. The second capping layer CPL2 may prevent the optical layer OPL from being damaged or contaminated by permeation of external impurities such as water or air.

The second capping layer CPL2 may be an inorganic layer, and be formed of silicon nitride (SiNₓ), aluminum nitride (AlNₓ), titanium nitride (TiNₓ), silicon oxide (SiOₓ), aluminum oxide (AlOₓ), titanium oxide (TiOₓ), silicon oxycarbide (SiOₓC_{y}), or silicon oxynitride (SiOₓN_{y}).

A planarization layer PLL may be disposed on the second capping layer CPL2. The planarization layer PLL may be disposed over the first, second, and third sub-pixels SPXL1, SPXL2, and SPXL3.

The planarization layer PLL may include an organic material such as acrylic resin, epoxy resin, phenol resin, polyamide resin, polyimide resin, polyester resin, polyphenylene sulfide resin, or benzocyclobutene (BCB). However, embodiments are not limited thereto. The planarization layer PLL may include various inorganic materials including silicon oxide (SiOₓ), silicon nitride (SiNₓ), silicon oxynitride (SiOₓN_{y}), aluminum nitride (AlNₓ), aluminum oxide (AlOₓ), zirconium oxide (ZrOₓ), hafnium oxide (HfOₓ), and titanium oxide (TiOₓ).

The color filter layer CFL may be disposed on the planarization layer PLL. The color filter layer CFL may include color filters CF1, CF2, and CF3 corresponding to the colors of the respective pixels PXL. Since the color filters CF1, CF2, and CF3 corresponding to the respective colors of the first, second, and third sub-pixels SPXL1, SPXL2, and SPXL3 are disposed, a full-color image may be displayed.

The color filter layer CFL may include a first color filter CF1 which is disposed in the first sub-pixel SPXL1 and selectively passes light emitted from the first sub-pixel SPXL1 therethrough, a second color filter CF2 which is disposed in the second sub-pixel SPXL2 and selectively passes light emitted from the second sub-pixel SPXL2 therethrough, and a third color filter CF3 which is disposed in the third sub-pixel SPXL3 and selectively passes light emitted from the third sub-pixel SPXL3 therethrough.

In one or more embodiments, the first color filter CF1, the second color filter CF2, and the third color filter CF3 may be respectively a red color filter, a green color filter, and a blue color filter, but embodiments are not limited thereto. Hereinafter, the term "color filter CF" or "color filters CF" will be used to designate any color filter among the first color filter CF1, the second color filter CF2, and the third color filter CF3, or collectively designate two or more kinds of color filters.

The first color filter CF1 may overlap the first color conversion layer CCL1 in the thickness direction of the substrate SUB (e.g., the third direction DR3). The first color filter CF1 may include a color filter material for selectively passing the first color of light (or red light) therethrough. For example, in case that the first sub-pixel SPXL1 is a red pixel, the first color filter CF1 may include a red color filter material.

The second color filter CF2 may overlap the second color conversion layer CCL2 in the thickness direction of the substrate SUB (e.g., the third direction DR3). The second color filter CF2 may include a color filter material for selectively passing the second color of light (or green light) therethrough. For example, in case that the second sub-pixel SPXL2 is a green pixel, the second color filter CF2 may include a green color filter material.

The third color filter CF3 may overlap the light scattering layer LSL in the thickness direction of the base layer BSL (e.g., the third direction DR3). The third color filter CF3 may include a color filter material for selectively passing the third color of light (or blue light) therethrough. For example, in case that the third sub-pixel SPXL3 is a blue pixel, the third color filter CF3 may include a blue color filter material.

In one or more embodiments, a light blocking layer BM may be further disposed between the first, second, and third color filters CF1, CF2, and CF3. In case that the light blocking layer BM is formed between the first, second, and third color filters CF1, CF2, and CF3, a color mixing defect, which is visible from a front surface or side surface of the display device DD, may be prevented from occurring. The material of the light blocking layer BM is not limited thereto, and various light blocking materials may be used to form the light blocking layer BM. For example, the light blocking layer BM may include a black matrix, or be embodied by stacking the first, second, and third color filters CF1, CF2, and CF3.

An overcoat layer OC may be disposed on the color filter layer CFL. The overcoat layer OC may be disposed over the first, second, and third sub-pixels SPXL1, SPXL2, and SPXL3. The overcoat layer OC may cover a lower component including the color filter layer CFL. The overcoat layer OC may prevent water or air from permeating the lower component. Furthermore, the overcoat layer OC may protect the lower component from a foreign material such as dust.

The overcoat layer OC may include an organic material such as acrylic resin, epoxy resin, phenol resin, polyamide resin, polyimide resin, polyester resin, polyphenylene sulfide resin, or benzocyclobutene (BCB). However, embodiments are not limited thereto. The overcoat layer OC may include various inorganic materials including silicon oxide (SiOₓ), silicon nitride (SiNₓ), silicon oxynitride (SiOₓN_{y}), aluminum nitride (AlNₓ), aluminum oxide (AlOₓ), zirconium oxide (ZrOₓ), hafnium oxide (HfOₓ), and titanium oxide (TiOₓ).

The outer film layer OFL may be disposed on the overcoat layer OC. The outer film layer OFL may be disposed on a perimeter of the display device DD, thus mitigating external influence. The outer film layer OFL may be disposed over the first, second, and third sub-pixels SPXL1, SPXL2, and SPXL3. In one or more embodiments, the outer film layer OFL may include one of a polyethyleneterephthalate (PET) film, a low reflection film, a polarizing film, and a transmittance controllable film, but embodiments are not limited thereto. In one or more embodiments, the pixel PXL may include an upper substrate other than including the outer film layer OFL.

For example, the structure of the pad area PDA in accordance with one or more embodiments will be described with reference to FIGS. 13 to 15. Redundant description of the embodiments described above will be simplified, or may not be repeated for descriptive convenience.

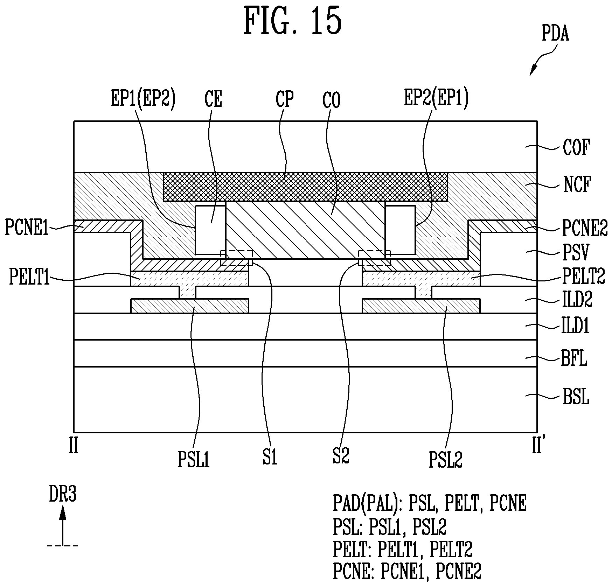

FIG. 13 is a schematic block diagram for describing an electrical connection structure of a conductive element CE in the pad area PDA in accordance with one or more embodiments. FIGS. 14 and 15 are schematic views illustrating the pad area PDA in accordance with one or more embodiments. For example, FIG. 14 is a schematic enlarged view of area EA2 of FIG. 4. FIG. 15 is a schematic sectional view taken along line II-II' of FIG. 14.

Referring to FIG. 13, the conductive element CE may electrically connect two or more components to each other in the pad area PDA. For example, the conductive element CE may electrically connect the pad line PAL for forming the pad PAD to the chip-on-film COF. In one or more embodiments, a portion of the conductive pattern layer CO of the conductive element CE may be electrically connected to the pad line PAL. Another portion of the conductive pattern layer CO may be electrically connected to the chip-on-film COF. For example, the chip-on-film COF may be electrically connected to the pad line PAL.

For example, the conductive element CE that electrically connects components in the pad area PDA may have the same configuration as that of the conductive element CE in the above-mentioned display area DA.

In one or more embodiments, the conductive element CE in the pad area PDA may function as a component for electrically connecting components to each other, rather than functioning as a light emitting element. The conductive element CE may select an appropriate electrical connection structure according to a function to be implemented, so that the degree of freedom of a process of designing the display area DA and the pad area PDA may be enhanced.

FIG. 14 illustrates an overlap structure of the chip-on-film COF and the pad PAD in a plan view. Referring to FIG. 14, the pads PAD may overlap portions of the chip-on-film COF, e.g., in a plan view. For example, pads PAD may be formed, and each pad PAD may overlap a portion of the chip-on-film COF. Each of the pads PAD may be electrically connected to the chip-on-film COF, and may be supplied with an electrical signal.

For example, a cross-sectional structure illustrating an electrical connection structure of the conductive element CE in the pad area PDA will be described with reference to FIG. 15. Referring to FIG. 15, pad lines PAL (or pad lines PAL that form the pads PAD) may include lower pad lines PSL, alignment pad lines PELT, and connection pad lines PCNE.

The lower pad lines PSL may be disposed on the base layer BSL. The lower pad lines PSL may be disposed below the passivation layer PSV. The lower pad lines PSL may be disposed on the first interlayer insulating layer ILD1, and may be covered by the second interlayer insulating layer ILD2. In one or more embodiments, the lower pad lines PSL and the above-mentioned source/drain layer SDL may be disposed in the same layer or may be formed of the same layer (or the same material). For example, the lower pad lines PSL and the source/drain layer SDL (e.g., the first transistor electrode TE1, the second transistor electrode TE2, and the power line PL) may be patterned by the same process. In one or more embodiments, the lower pad lines PSL may include a first lower pad line PSL1, and a second lower pad line PSL2 spaced apart from the first lower pad line PSL1.

In one or more embodiments, the alignment pad lines PELT may be disposed on the second interlayer insulating layer ILD2. In one or more embodiments, the alignment pad lines PELT and the above-mentioned alignment electrodes ELT may be formed of the same layer (or the same material). For example, the alignment pad lines PELT and the alignment electrodes ELT may be patterned by the same process. In one or more embodiments, the alignment pad lines PELT may include a first alignment pad line PELT1 and a second alignment pad line PELT2.

In one or more embodiments, the alignment pad lines PELT may be connected (e.g., electrically connected) to the lower pad lines PSL. For example, the first alignment pad line PELT1 may be connected (e.g., electrically connected) to the first lower pad line PSL1 through a contact hole passing through the second interlayer insulating layer ILD2. The second alignment pad line PELT2 may be connected (e.g., electrically connected) to the second lower pad line PSL2 through a contact hole passing through the second interlayer insulating layer ILD2. The alignment pad lines PELT may be connected (e.g., electrically connected) to the connection pad lines PCNE. For example, the alignment pad lines PELT may electrically connect the lower pad lines PSL to the connection pad lines PCNE.

The connection pad lines PCNE may be disposed on the alignment pad lines PELT. For example, a portion of the connection pad lines PCNE may be disposed on the alignment pad lines PELT, and the other portion of the connection pad lines PCNE may be disposed on the passivation layer PSV. In one or more embodiments, the connection pad lines PCNE may contact (e.g., directly contact) the alignment pad lines PELT. In one or more embodiments, the connection pad lines PCNE may include a first connection pad line PCNE1 and a second connection pad line PCNE2. In one or more embodiments, the connection pad lines PCNE and the first connection electrode CNE1 and/or the second connection electrode CNE2 may may be formed of the same layer (or the same material). For example, the first connection pad line PCNE1 and the first connection electrode CNE1 may be patterned by the same process. The second connection pad line PCNE2 and the second connection electrode CNE2 may be patterned by the same process. In one or more embodiments (for example, FIG. 10), in case that the first connection electrode CNE1 and the second connection electrode CNE2 are patterned by the same process, the first and second connection pad lines PCNE1 and PCNE2 and the first and second connection electrodes CNE1 and CNE2 may be patterned by the same process.

In one or more embodiments, the connection pad lines PCNE may be connected (e.g., electrically connected) to the alignment pad lines PELT. For example, the first connection pad line PCNE1 may be connected (e.g., electrically connected) to the first alignment pad line PELT1. The second connection pad line PCNE2 may be connected (e.g., electrically connected) to the second alignment pad line PELT2.

The conductive element CE may be disposed on the pad lines PAL in the pad area PDA. For example, the first end portion EP1 (or the second end portion EP2) of the conductive element CE may face (or overlap) the first alignment pad line PELT1 and the first connection pad line PCNE1. The second end portion EP2 (or the first end portion EP1) of the conductive element CE may face (or overlap) the second alignment pad line PELT2 and the second connection pad line PCNE2.

The conductive element CE may be disposed between the chip-on-film COF and the pad lines PAL. For example, the conductive element CE may be disposed between the chip-on-film COF and the connection pad lines PCNE. The conductive element CE may be disposed between a conductive connector CP and the connection pad lines PCNE. The conductive element CE may be disposed between adjacent non-conductive coupling layers NCF.

In one or more embodiments, the conductive element CE may be disposed between the first alignment pad line PELT1 and the second alignment pad line PELT2. Conductive elements CE may be formed. Each of the conductive elements CE may be aligned to overlap the first alignment pad line PELT1 and the second alignment pad line PELT2. In one or more embodiments, the conductive element CE may be disposed between the first connection pad line PCNE1 and the second connection pad line PCNE2, e.g., in a length direction (or an extension direction) of the conductive element CE. In one or more embodiments, the conductive element CE may be aligned to overlap the first alignment pad line PELT1 and the second alignment pad line PELT2 in the pad area PDA in a manner similar to that of the process of disposing the conductive element CE in the display area DA. For example, ink INK including the conductive element CE may be supplied onto the first alignment pad line PELT1 and the second alignment pad line PELT2, a first alignment signal may be applied to the first alignment pad line PELT1, and a second alignment signal may be supplied to the second alignment pad line PELT2. The conductive element CE in the pad area PDA may be aligned on the alignment pad lines PELT based on an electric field derived from electrical signals supplied to the alignment pad lines PELT. In one or more embodiments, the conductive element CE may be supplied to the pad area PDA after the connection pad liens PCNE are patterned. Thus, the conductive element CE may be disposed on the connection pad lines PCNE.

In one or more embodiments, the aligned conductive element CE may be electrically connected to the alignment pad line PELT and the connection pad line PCNE. The conductive pattern layer CO of the conductive element CE may be electrically connected to the alignment pad line PELT and the connection pad line PCNE. For example, the conductive pattern layer CO may contact the connection pad line PCNE, so that the pad lines PAL may be electrically connected to the conductive pattern layer CO. A portion of the conductive pattern layer CO may contact the first connection pad line PCNE1 in a first area S1. Another portion of the conductive pattern layer CO may contact the second connection pad line PCNE2 in a second area S2. In one or more embodiments, an outer surface of the conductive element CE on which the conductive pattern layer CO is not disposed (or not patterned) may be spaced apart from the pad lines PAL.

In one or more embodiments, the second length L2 of the conductive pattern layer CO may be at least greater than a distance (or gap) between the first connection pad line PCNE1 and the second connection pad line PCNE2. For example, a first end portion of the conductive pattern layer CO may contact the first connection pad line PCNE1, and a second end portion of the conductive pattern layer CO may contact the second connection pad line PCNE2.

In one or more embodiments, a non-conductive coupling layer NCF may be formed on the pad lines PAL. The non-conductive coupling layer NCF may couple the connection pad line PCNE to the chip-on-film COF and the conductive connector CP. The non-conductive coupling layer NCF may include an adhesive material for coupling two or more components to each other. In one or more embodiments, the non-conductive coupling layer NCF may include a non-conductive film.

The chip-on-film COF may be electrically connected to the pad lines PAL through the conductive element CE. For example, the chip-on-film COF may be electrically connected to, by the conductive connector CP, the conductive element CE that is electrically connected to the pad lines PAL. For example, a portion of the chip-on-film COF may be coupled to the conductive connector CP. For example, the conductive connector CP may contact a portion of the conductive pattern layer CO. For example, the conductive connector CP may be disposed between the conductive pattern layer CO and the chip-on-film COF, and may electrically connect the chip-on-film COF to the conductive pattern layer CO. Therefore, the conductive connector CP and the conductive pattern layer CO may apply, to the pad lines PAL, electrical signals supplied from the chip-on-film COF. The conductive connector CP may include various conductive materials. For example, the conductive connector CP may include one or more materials selected from the group consisting of tin (Sn) and copper (Cu). However, embodiments are not limited thereto.

The chip-on-film COF may be coupled to one or more components on the base layer BSL through the non-conductive coupling layer NCF. For example, the chip-on-film COF may be coupled to the connection pad lines PCNE through the non-conductive coupling layer NCF. However, embodiments are not limited thereto. In one or more embodiments, one or more insulating layers may be disposed on the connection pad lines PCNE, and the chip-on-film COF may be coupled to the one or more insulating layers through the non-conductive coupling layer NCF.

In one or more embodiments, the conductive pattern layer CO of the conductive element CE may form an electrical path in the thickness direction of the base layer BSL (e.g., in the third direction DR3). For example, the pad lines PAL, the conductive element CE, and the chip-on-film COF may overlap each other in a plan view, and electrical signals supplied from the flexible circuit component FPCB may be supplied to the pad lines PAL through the chip-on-film COF and the conductive pattern layer CO.

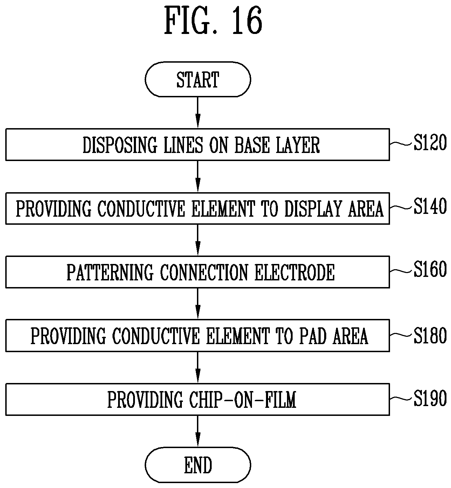

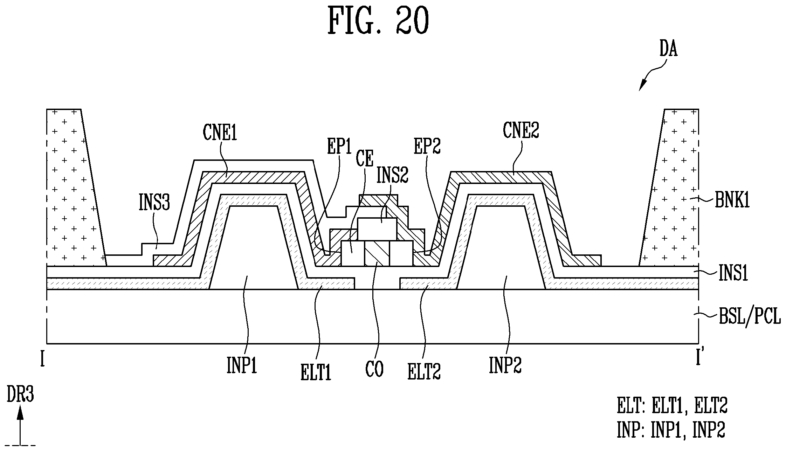

For example, a method of fabricating the display device DD in accordance with one or more embodiments will be described with reference to FIGS. 16 to 24. Redundant description of the embodiments described above will be simplified, or may not be repeated for descriptive convenience.

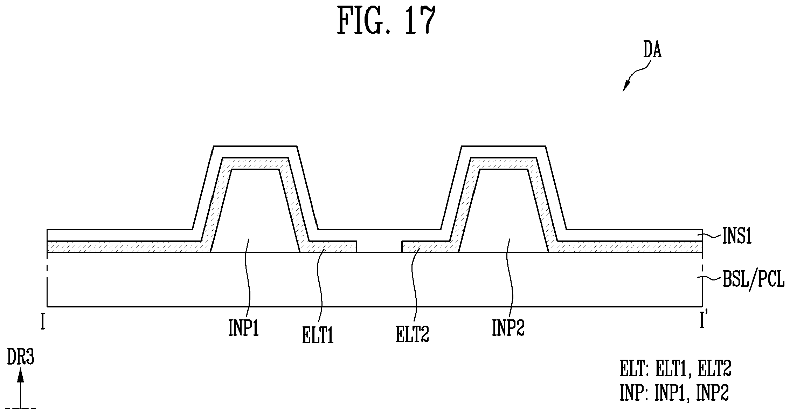

FIG. 16 is a schematic flowchart illustrating a method of fabricating the display device in accordance with one or more embodiments. FIGS. 17 to 24 are schematic views illustrating, by process steps, a method of fabricating the display device in accordance with one or more embodiments.

FIGS. 17 to 20 illustrate the fabrication method, based on the cross-sectional structure described above with reference to FIG. 7. FIGS. 17 to 20 illustrate the fabrication method based on the cross-sectional structure in the display area DA. In FIGS. 17 to 20, the illustration of the pixel circuit layer PCL is simplified for convenience of explanation.

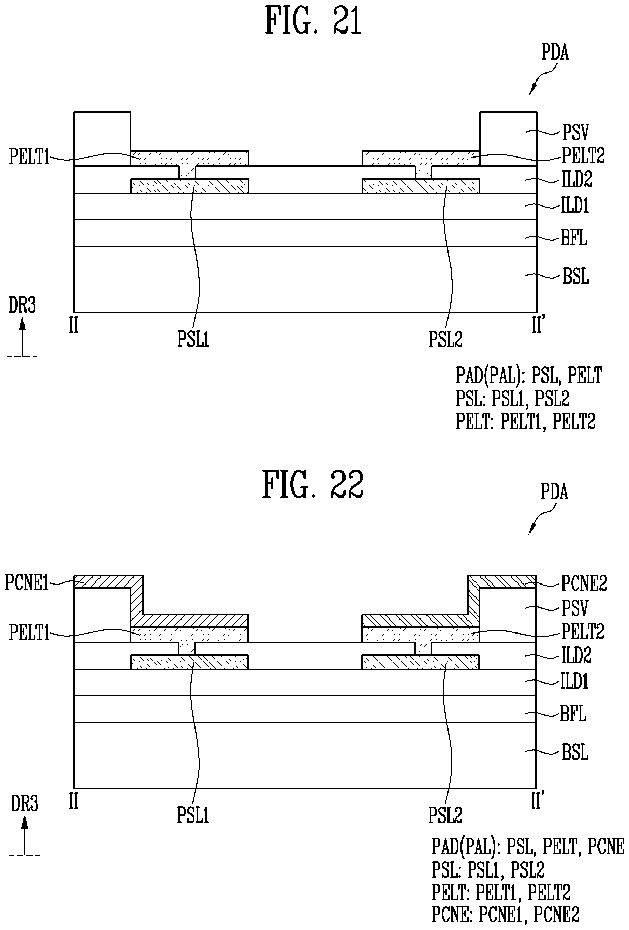

FIGS. 21 to 24 illustrate the fabrication method, based on the cross-sectional structure described above with reference to FIG. 15. FIGS. 21 to 24 illustrate the fabrication method based on the cross-sectional structure in the pad area PDA.

Referring to FIG. 16, the method of fabricating the display device DD in accordance with one or more embodiments may include a step S120 of disposing lines on the base layer, a step S140 of providing a conductive element to the display area, a step S160 of patterning a connection electrode, a step S180 of providing a conductive element to the pad area, and a step S190 of providing a chip-on-film.

Referring to FIGS. 16, 17, and 21, in the step S120 of disposing the lines on the base layer, the pixel circuit layer PCL may be formed on the base layer BSL in the display area DA, and insulating layers and the lower pad lines PSL may be formed on the base layer BSL in the pad area PDA. Furthermore, the alignment electrodes ELT may be formed on the pixel circuit layer PCL in the display area DA, and the lower pad lines PSL may be formed in the pad area PDA.

In one or more embodiments, the electrodes (or the lines) and the insulating layers that are disposed on the base layer BSL may be formed by patterning a conductive layer (or a metal layer), an inorganic material, an organic material, and the like through a process by using a mask.

In the step S120, the source/drain layer SDL for forming the pixel circuit layer PCL may be patterned in the display area DA. In one or more embodiments, the insulating pattern layer INP may be formed on the pixel circuit layer PCL, and the alignment electrodes ELT may be formed (or patterned). The first insulating layer INS1 may be formed on the alignment electrodes ELT. In one or more embodiments, the first electrode ELT1 and the second electrode ELT2 may be spaced apart from each other with an area disposed therebetween, so that an area where the conductive elements CE may be aligned may be defined.

In the step S120, in the pad area PDA, the lower pad lines PSL may be patterned on the base layer BSL, and the alignment pad lines PELT that are connected (e.g., electrically connected) to the lower pad lines PSL may be patterned. For example, after the first and second lower pad lines PSL1 and PSL2 are disposed, the second interlayer insulating layer ILD2 in which contact holes are formed may be disposed, and the first and second alignment pad lines PELT1 and PELT2 may be disposed. Thereby, the first alignment pad line PELT1 connected (e.g., electrically connected) to the first lower pad line PSL1, and the second alignment pad line PELT2 connected (e.g., electrically connected) to the second lower pad line PSL2 may be formed. In one or more embodiments, the first alignment pad line PELT1 and the second alignment pad line PELT2 may be spaced apart from each other, so that an area where the conductive elements CE may be aligned may be defined.

In the step S120, after the second interlayer insulating layer ILD2 is disposed, the passivation layer PSV may be disposed, and may expose a portion of the second interlayer insulating layer ILD2 so that the alignment pad lines PELT may be disposed.

Referring to FIGS 16 and 18, in the step S140 of providing the conductive element to the display area, the conductive element CE may be aligned in the display area DA.

In the step S140, the first bank BNK1 may be disposed (or formed) on the first insulating layer INS1. For example, the first bank BNK1 may define space in which fluid is received.

In the step S140, the ink INK including the conductive elements CE may be supplied to the space that is defined by the first bank BNK1 and in which fluid is be received. For example, the ink INK including the conductive elements CE and a solvent SLV may be supplied on the base layer BSL by a printing device that sprays fluid. In one or more embodiments, the solvent SLV may include an organic solvent. For example, the solvent SLV may be one of propylene glycol methyl ether acetate (PGMEA), dipropylen glycol n-propyl ether (DGPE), and triethylene gylcol n-butyl ether (TGBE). However, embodiments are not limited thereto.

In the step S140, the ink INK may be received in the space defined by the first bank BNK1, and alignment signals may be supplied to the alignment electrode ELT, so that the conductive elements CE may be aligned based on an electric field derived (or generated) from the alignment signals. As described above, the first alignment signal may be supplied to the first electrode ELT1, and the second alignment signal may be supplied to the second electrode ELT2, so that the conductive elements CE may be aligned between the first electrode ELT1 and the second electrode ELT2. Subsequently, the solvent SLV may be removed (or dried).

In one or more embodiments, the conductive element CE may be aligned in an area in the display area DA, and in case that an anode signal and a cathode signal are supplied thereto by performing a subsequent process, the conductive element CE may emit light.

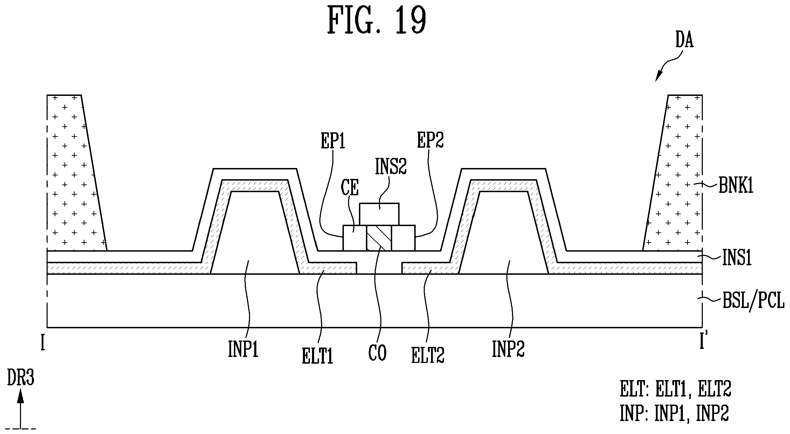

Referring to FIG. 19, the solvent SLV may be removed, and the second insulating layer INS2 may be disposed (or patterned) on the conductive element CE.

In the step S140, the second insulating layer INS2 may cover (e.g., entirely cover) the conductive pattern layer CO of the conductive element CE. For example, the second insulating layer INS2 may be patterned to overlap (e.g., entirely overlap) the conductive pattern layer CO, e.g., in a plan view. Therefore, a risk of electrical connection of the conductive pattern layer CO with the connection electrodes CNE1 and CNE2 in a subsequent process may be prevented from occurring.

Referring to FIGS. 16, 20, and 22, in the step S160 of patterning the connection electrode, the connection electrodes CNE1 and CNE2 may be patterned in the display area DA, and the connection pad lines PCNE may be patterned in the pad area PDA.

In the step S160, the first connection electrode CNE1 and the second connection electrode CNE2 may be patterned in the display area DA. For example, the first connection electrode CNE1 may be disposed to be connected (e.g., electrically connected) to the first end portion EP1 of the conductive element CE. The third insulating layer INS3 may be disposed to cover the first connection electrode CNE1. For example, the second connection electrode CNE2 may be disposed to be connected (e.g., electrically connected) to the second end portion EP2 of the conductive element CE. Therefore, the opposite end portions EP1 and EP2 of the conductive element CE may be connected (e.g., electrically connected) to the first and second connection electrodes CNE1 and CNE2, so that the conductive element CE disposed in the display area DA may emit light.

In one or more embodiments, the first connection electrode CNE1 and the second connection electrode CNE2 may be patterned by the same process. For example, the first connection electrode CNE1 and the second connection electrode CNE2 may be formed by deposition at the same time, and may include the same material.

In the step S160, the first connection pad line PCNE1 and the second connection pad line PCNE2 may be patterned in the pad area PDA. For example, the first connection pad line PCNE1 may be disposed on the first alignment pad line PELT1 and connected (e.g., electrically connected) to the first alignment pad line PELT1. The second connection pad line PCNE2 may be disposed on the second alignment pad line PELT2 and connected (e.g., electrically connected) to the second alignment pad line PELT2.

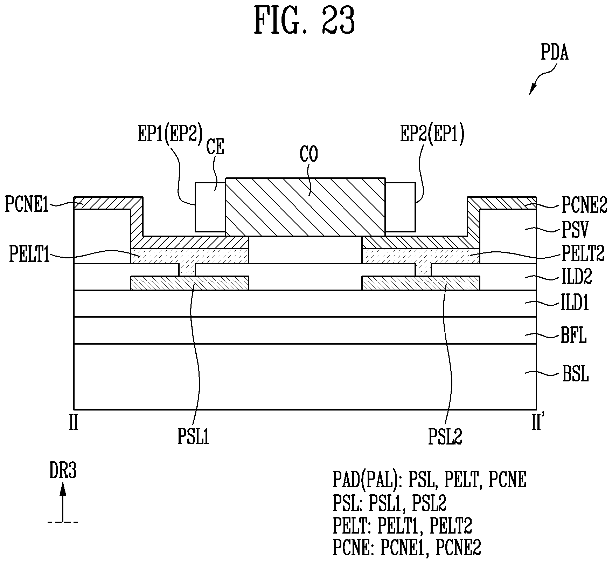

Referring to FIGS 16 and 23, in the step S180 of providing the conductive element to the pad area, the conductive element CE may be aligned in the pad area PDA.

In one or more embodiments, the conductive element CE that is aligned in the pad area PDA and the conductive element CE that is aligned in the display area DA may refer to the same object. For example, process equipment (e.g., a printing device, and the like) used to supply the conductive element CE to the display area DA may also be used to supply the conductive element CE to the pad area PDA.

In the step S180, the conductive element CE may be aligned between the first alignment pad line PELT1 and the second alignment pad line PELT2 in a manner similar to that of the step S140 of providing the conductive element CE to the display area DA. For example, a first alignment signal (e.g., an AC signal) may be supplied to the first alignment pad line PELT1 and the first connection pad line PCNE1, and a second alignment signal (e.g., a ground signal) may be supplied to the second alignment pad line PELT2 and the second connection pad line PCNE2. For example, in the pad area PDA, the conductive element CE may be aligned based on an electric field derived (or generated) from the first alignment signal and the second alignment signal. In one or more embodiments, the orientation of the first end portion EP1 or the second end portion EP2 of the conductive element CE on the pad lines PAL is not limited thereto.

In the step S180, the conductive element CE may be electrically connected to the pad lines PAL. For example, the conductive pattern layer CO of the conductive element CE may be connected (e.g., electrically connected) to the connection pad lines PCNE.

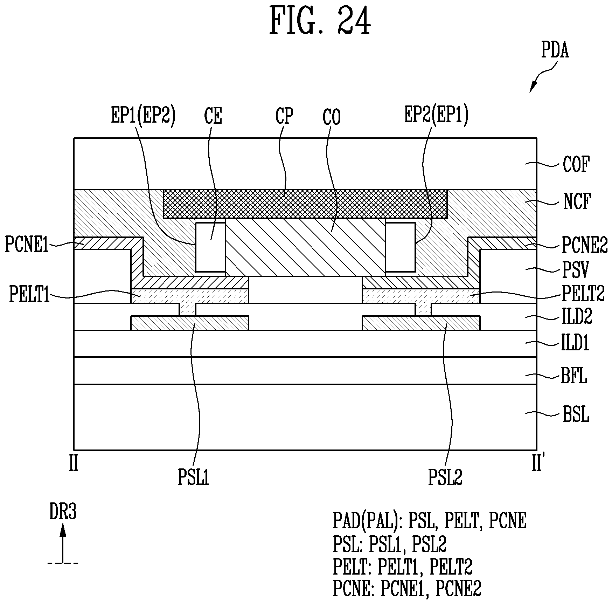

Referring to FIGS. 16 and 24, in the step S190 of providing the chip-on-film COF, the chip-on-film COF may be electrically connected to the conductive element CE and the pad lines PAL.

In the step S190, the non-conductive coupling layer NCF may be disposed, and the chip-on-film COF coupled to the conductive connector CP may be disposed on the conductive element CE. For example, the conductive pattern layer CO of the conductive element CE may be connected (e.g., electrically connected) to the conductive connector CP, so that the chip-on-film COF may be electrically connected to the pad lines PAL through the conductive connector CP and the conductive pattern layer CO.

For example, the conductive element CE in accordance with one or more embodiments may function as a light emitting element in the display area DA, and may also function as an electrical connector in the thickness direction of the base layer BSL in the pad area PDA. Therefore, the process equipment may be simplified, whereby the process cost may be reduced.

Subsequently, the color conversion layer CCL and the color filter layer CFL may be formed, thus completing the fabrication of the display device DD in accordance with one or more embodiments.

In concluding the detailed description, those skilled in the art will appreciate that many variations and modifications may be made to the embodiments without substantially departing from the principles and spirit and scope of the disclosure. Therefore, the disclosed embodiments are used in a generic and descriptive sense only and not for purposes of limitation.

## Claims

1. A conductive element comprising:
a first semiconductor layer adjacent to a first end portion of the conductive element;
a second semiconductor layer adjacent to a second end portion of the conductive element;
an active layer disposed between the first semiconductor layer and the second semiconductor layer;
an element insulating layer covering the active layer and exposing the first end portion and the second end portion; and
a conductive pattern layer disposed on the element insulating layer.

2. The conductive element of claim 1, wherein
the conductive pattern layer surrounds the element insulating layer in a cross-sectional direction of the conductive element, and
the cross-sectional direction is different from a direction from the first end portion toward the second end portion.

3. The conductive element of claim 1, wherein the conductive pattern layer includes a conductive material, and is electrically insulated from the first semiconductor layer, the second semiconductor layer, and the active layer by the element insulating layer.

4. The conductive element of claim 1, wherein the conductive pattern layer exposes a first portion of the element insulating layer adjacent to the first end portion and a second portion of the element insulating layer adjacent to the second end portion.

5. The conductive element of claim 1, wherein the conductive pattern layer has a thickness in a range of about 200 nm to about 350 nm.

6. The conductive element of claim 1, wherein
the conductive element has a first length in a direction from the first end portion toward the second end portion,
the conductive pattern layer has a second length in the direction from the first end portion toward the second end portion, and
a ratio of the first length to the second length is in a range of about 1.3 to about 1.6.

7. A display device comprising:
a pad line disposed in a pad area on a base layer, the pad line including a first alignment pad line and a second alignment pad line;
a conductive element including at least a portion disposed on the first alignment pad line and the second alignment pad line; and
a chip-on-film including a first portion electrically connected to the conductive element and a second portion electrically connected to a flexible circuit component,
wherein the conductive element comprises:
a first semiconductor layer adjacent to a first end portion of the conductive element;
a second semiconductor layer adjacent to a second end portion of the conductive element;
an active layer disposed between the first semiconductor layer and the second semiconductor layer;
an element insulating layer covering the active layer and exposing the first end portion and the second end portion; and
a conductive pattern layer disposed on the element insulating layer, the conductive pattern layer electrically connecting the pad line to the chip-on-film.

8. The display device of claim 7, wherein
the first alignment pad line and the second alignment pad line are spaced apart from each other, and
the conductive element comprises a plurality of conductive elements disposed between the first alignment pad line and the second alignment pad line.

9. The display device of claim 7, wherein the conductive pattern layer physically contacts at least a portion of the pad line.

10. The display device of claim 9, wherein
the pad line comprises a first connection pad line on the first alignment pad line, and a second connection pad line on the second alignment pad line,
the first alignment pad line and the second alignment pad line are spaced apart from each other,
a first portion of the conductive pattern layer physically contacts the first connection pad line, and
a second portion of the conductive pattern layer physically contacts the second connection pad line.

11. The display device of claim 7, wherein a distance between the first alignment pad line and the second alignment pad line is smaller than a length of the conductive pattern layer.

12. The display device of claim 7, comprising:
a non-conductive coupling layer coupling the chip-on-film to at least some of components disposed on the base layer; and
a conductive connector disposed between the chip-on-film and the conductive pattern layer, the conductive connector electrically connecting the chip-on-film to the conductive pattern layer.

13. The display device of claim 7, further comprising:
electrodes disposed in a display area on the base layer, each electrode including a first electrode and a second electrode,
wherein a portion of the conductive element is aligned between the first electrode and the second electrode to emit light in the display area.

14. The display device of claim 13, further comprising:
a first insulating layer disposed on the first electrode and the second electrode; and
insulating pattern layers disposed on the first insulating layer and protruding in a thickness direction of the base layer.

15. The display device of claim 13, further comprising:
a first connection electrode electrically connected to the first end portion of the conductive element in the display area; and
a second connection electrode electrically connected to the second end portion of the conductive element in the display area,
wherein the first connection electrode and the second connection electrode are electrically insulated from the conductive pattern layer.

16. The display device of claim 13, further comprising:
a first connection electrode electrically connected to the first end portion of the conductive element in the display area; and
a second connection electrode electrically connected to the second end portion of the conductive element in the display area,
wherein the first connection electrode and the second connection electrode are electrically insulated from the conductive pattern layer, and are formed of a same layer.

17. The display device of claim 13, further comprising:
a first insulating layer disposed on the first electrode and the second electrode,
wherein the conductive element and the first insulating layer in the display area form an empty space in an area where the conductive pattern layer is not disposed.

18. The display device of claim 17, further comprising:
a second insulating layer entirely covering the conductive pattern layer of the conductive element in the display area.

19. A display device comprising:
a first electrode and a second electrode disposed on a base layer;
a conductive element disposed on the first electrode and the second electrode;
a first connection electrode electrically connected to a first end portion of the conductive element; and
a second connection electrode electrically connected to a second end portion of the conductive element,
wherein the conductive element comprises:
a first semiconductor layer adjacent to the first end portion;
a second semiconductor layer adjacent to the second end portion;
an active layer disposed between the first semiconductor layer and the second semiconductor layer;
an element insulating layer covering the active layer and exposing the first end portion and the second end portion; and
a conductive pattern layer disposed on the element insulating layer.

20. A display device comprising:
a pad line disposed on a base layer;
a plurality of conductive elements electrically connected to the pad line;
a chip-on-film including a first portion electrically connected to the plurality of conductive elements and a second portion electrically connected to a flexible circuit component; and
a non-conductive coupling layer coupling the chip-on-film to some of components disposed on the base layer.

21. A method of fabricating a display device, the method comprising:
disposing electrodes on a base layer including a pad area and a display area, the electrodes including alignment pad lines disposed in the pad area and alignment electrodes disposed in the display area;
disposing conductive elements on the alignment electrodes in the display area;
patterning connection electrodes on the base layer;
disposing the conductive elements on the alignment pad lines in the pad area; and
electrically connecting a chip-on-film to the conductive elements in the pad area, the chip-on-film electrically connected to a flexible circuit component.

22. The method of claim 21, wherein the disposing of the conductive elements in the display area comprises:
supplying ink including the conductive elements onto the base layer;
applying an alignment signal to each of the electrodes; and
aligning the conductive elements on the electrodes by an electric field formed by the alignment signal.

23. The method of claim 21, wherein an equipment used to dispose the conductive elements in the display area is substantially identical to an equipment used to dispose the conductive elements in the pad area.

24. The method of claim 21, wherein the patterning of the connection electrodes comprises:
patterning a first connection electrode and a second connection electrode which are electrically connected to the conductive elements in the display area; and
patterning connection pad lines on the alignment pad lines in the pad area.

25. The method of claim 24, wherein each of the conductive elements comprises:
a first semiconductor layer adjacent to a first end portion of each conductive element;
a second semiconductor layer adjacent to a second end portion of each conductive element;
an active layer disposed between the first semiconductor layer and the second semiconductor layer;
an element insulating layer covering the active layer and exposing the first end portion and the second end portion; and
a conductive pattern layer disposed on the element insulating layer, and
wherein the disposing of the conductive elements in the pad area comprises disposing the connection pad lines into contact with the conductive pattern layer.

26. The method of claim 25, wherein the electrically connecting of the chip-on-film to the conductive elements in the pad area comprises electrically connecting the conductive pattern layer to the chip-on-film through a conductive connector.
